(19) **Europäisches Patentamt**
**European Patent Office**
**Office européen des brevets**

(11) **EP 1 272 683 B2**

(12) # NEUE EUROPÄISCHE PATENTSCHRIFT
Nach dem Einspruchsverfahren

(45) Veröffentlichungstag und Bekanntmachung des Hinweises auf die Entscheidung über den Einspruch:
**26.03.2025 Patentblatt 2025/13**

(45) Hinweis auf die Patenterteilung:
**30.11.2005 Patentblatt 2005/48**

(21) Anmeldenummer: **00993868.9**

(22) Anmeldetag: **27.12.2000**

(51) Internationale Patentklassifikation (IPC):
**C23C 16/26** (2006.01)   **C23C 16/02** (2006.01)
**H01J 37/32** (2006.01)   **C23C 14/35** (2006.01)

(52) Gemeinsame Patentklassifikation (CPC):
**H01J 37/32055; C23C 16/029; C23C 16/26; C23C 28/044; C23C 28/046; C23C 28/048; C23C 28/42;** F16C 33/043

(86) Internationale Anmeldenummer:
**PCT/EP2000/013299**

(87) Internationale Veröffentlichungsnummer:
**WO 2001/079585 (25.10.2001 Gazette 2001/43)**

(54) **DLC-SCHICHTSYSTEM SOWIE VERFAHREN ZUR HERSTELLUNG EINES DERARTIGEN SCHICHTSYSTEMS**

DLC LAYER SYSTEM AND METHOD FOR PRODUCING SAID LAYER SYSTEM

SYSTEME DE COUCHES DLC ET PROCEDE POUR PRODUIRE UN TEL SYSTEME

(84) Benannte Vertragsstaaten:
**AT BE CH CY DE DK ES FI FR GB GR IE IT LI LU MC NL PT SE TR**

(30) Priorität: **12.04.2000 DE 10018143**

(43) Veröffentlichungstag der Anmeldung:
**08.01.2003 Patentblatt 2003/02**

(60) Teilanmeldung:
**03014612.0 / 1 362 931**

(73) Patentinhaber: **Oerlikon Surface Solutions AG, Pfäffikon**
**8808 Pfäffikon SZ (CH)**

(72) Erfinder:
• **MASSLER, Orlaw**
  **A-6800 Feldkirch (AT)**
• **PEDRAZZINI, Mauro**
  **FL-9492 Eschen (LI)**
• **WOHLRAB, Christian**
  **A-6800 Feldkirch (AT)**
• **EBERLE, Hubert**
  **FL-9496 Balzers (LI)**
• **GRISCHKE, Martin**
  **FL-9494 Schaan (LI)**
• **MICHLER, Thorsten**
  **55128 Mainz (DE)**

(74) Vertreter: **Hecht, Jan-David**
**Patentanwaltskanzlei Dr. Hecht**
**Ranstädter Steinweg 28**
**04109 Leipzig (DE)**

(56) Entgegenhaltungen:
| | |
|---|---|
| EP-A1- 0 229 936 | EP-A1- 0 306 612 |
| EP-A1- 0 579 983 | WO-A1-97/34315 |
| US-A- 5 709 784 | US-A- 5 750 210 |
| US-A- 5 768 046 | US-A- 6 066 399 |
| US-A- 6 066 399 | |

• **Abschlussbericht des Bundesministeriums für Bildung. Wissen-schatt, Forschung und Technologie (BMBF) Oberflächen und Schichttechnologien, Förderkennzeichen 13N6220**
• **PATENT ABSTRACTS OF JAPAN vol. 012, no. 040 (C - 474) 5 February 1988 (1988-02-05)**
• **PATENT ABSTRACTS OF JAPAN vol. 1998, no. 14 31 December 1998 (1998-12-31)**
• **PATENT ABSTRACTS OF JAPAN vol. 1998, no. 14 31 December 1998 (1998-12-31)**
• **PATENT ABSTRACTS OF JAPAN vol. 1998, no. 14 31 December 1998 (1998-12-31)**

EP 1 272 683 B2

**Beschreibung**

Die vorliegende Erfindung betrifft ein Schichtsystem nach Patenanspruch 1, ein Verfahren nach Patenanspruch 16 sowie eine Vorrichtung nach Patenanspruch 24. Bevorzugte Ausführungen der Erfindung werden in den Unteransprüchen 2 bis 15, 17 bis 23 sowie in der Beschreibung, Beispielen und Zeichnungen offengelegt.

Trotz der herausragenden Eigenschaften von diamantähnlichem Kohlenstoffschichten (DLC-Schichten), wie hoher Härte und ausgezeichneter Gleiteigenschaften, und einer langjährigen weltweiten Forschungstätigkeit, konnten bis heute noch keine reinen DLC-Schichten hergestellt werden, die auch bei grösseren Schichtdicken (> 1 $\mu$m) eine für den industriellen Einsatz in typischen Verschleissschutzanwendungen ausreichende Schichthaftung zeigen und eine ausreichende Leitfähigkeit aufweisen, um auf die mit vielen produktionstechnischen Nachteilen behafteten Hochfrequenz (HF)-Verfahren zur Herstellung verzichten zu können.

Als typische Verschleissschutzanwendungen seien hier einerseits Anwendungen im Maschinenbaubereich, wie Schutz vor Gleitverschleiss, Pitting, Kaltverschweissung etc., insbesondere auf Bauteilen mit gegeneinander bewegten Flächen, wie beispielsweise Zahnrädern, Pumpen- und Tassenstössel, Kolbenringe, Injektorennadeln, komplette Lagersätze oder deren einzelne Bestandteile u.v.a. genannt, sowie andererseits Anwendungen im Bereich der Materialbearbeitung zum Schutz der eingesetzten Werkzeuge zur spanenden oder umformenden Bearbeitung sowie bei Spritzgussformen.

Neben der vielseitigen Anwendungsmöglichkeiten im Verschleissschutzbereich sei hier noch ausdrücklich der Korrosionsschutz als weiterer vielversprechender Anwendungsbereich von derartigen DLC-Schichten genannt.

Reine DLC-Schichten können heute auf Grund der hohen Eigenspannungen und der damit verbundenen problematischen Haftung, insbesondere bei hochbeanspruchten Flächen im Verschleissschutz nur mit geringen, für viele Anwendungen unzureichenden Schichtdicken abgeschieden werden oder müssen durch zusätzlichen Einbau von Fremdatomen, wie beispielsweise Silizium, verschiedenen Metallen und Fluor in ihren Eigenschaften verändert werden. Allerdings war die damit erreichte Verringerung der Schichteigenspannungen und Verbesserung der Haftung immer mit einem deutlichem Härteverlust verbunden, der sich gerade im Verschleissschutzbereich oftmals negativ auf die Lebensdauer des jeweils beschichteten Gegenstands auswirken kann.

Ein zusätzliches Aufbringen von Einlaufschichten, die beispielsweise graphitischen Kohlenstoff und/oder eine Mischung aus Metall bzw. Metallkarbid und Kohlenstoff enthalten, konnte daher nicht in Betracht gezogen werden, da einerseits durch die zum Erreichen des Einlaufeffekts notwendige Mindestschichtdicke weitere schädliche Schichteigenspannungen aufgebaut wurden und andererseits die Haftung auf reinen Kohlenstoffschichten problematisch war. Erst solche Schichten können aber durch die Kombination der sehr harten Kohlenstoffschicht, bzw. Diamantschicht mit der darauf abgeschiedenen Gleit- bzw. Einlaufschicht den zunehmenden Anforderungen für Bauteile, wie sie beispielsweise für einzelne Komponenten im modernen Motorenbau gefordert werden entsprechen.

Bei heute üblichen plasmagestützten Verfahren zur Herstellung von DLC-Schichten werden auf Grund des hohen elektrischen Widerstandes harter DLC-Schichten häufig, um störende Aufladungen während der Beschichtung zu vermeiden, Prozesse mit einem HF-Bias bzw. - Plasma (als HF = Hochfrequenz werden im folgenden alle Frequenzen > 10 MHz verstanden), insbesondere mit der Industriefrequenz 13,56 MHz, angewandt. Die bekannten Nachteile dieser Technik, sind schwer beherrschbare Störungen elektronisch empfindlicher Prozesssteuerungseinheiten (HF-Rückkopplungen, Senderwirkung, ...) ein erhöhter Aufwand um HF-Ueberschläge zu vermeiden, Antennenwirkung der zu beschichtenden Substrate und ein damit verbundener relativ grosser Mindestabstand zwischen dem Beschichtungsgut, der eine optimale Raum- und Flächennutzung in der Beschichtungskammer verhindert. So ist bei HF-Verfahren genauestens darauf zu achten, dass es, beispielsweise durch eine zu hohe Beladungsdichte, falsche Substrat / Halterungsabstände etc., nicht zu einer Überlappung von Dunkelräumen kommt, wodurch schädliche Nebenplasmen entstehen. Derartige Nebenplasmen bilden einerseits Energiesenken und belasten so zusätzlich die Plasmageneratoren, andererseits kommt es durch derartige lokale Plasmakonzentrationen häufig zu einer thermischen Überhitzung der Substrate und unerwünschter Graphitisierung der Schicht.

Auf Grund der bei HF-Prozessen berechneten exponentiellen Abhängigkeit der Substratspannung von der Substratoberfläche

$$US/UE = CE/CS = (AE/AS)4$$

wobei U für die Spannung, C für die Kapazität, A für die Oberfläche und die Indizes S für Substrat bzw. E für die Gegenelektrode stehen, kommt es bei steigender Substratoberfläche AS zu einem starken Abfall der Substratspannung US begleitet von einem starken Anstieg der Verlustleistung. Daher kann abhängig von der Leistungsfähigkeit der eingesetzten Generatoren nur eine bestimmte Maximalfläche beschichtet werden. Anderenfalls kann entweder nicht genügend Leistung in das System eingebracht bzw. die Potentialdifferenz (Substratspannung) nicht ausreichend hoch eingestellt werden, um den für gut haftende dichte Schichten notwendigen Ionplatingeffekt zu erzielen.

Ferner ist auf der Anlagenseite bei HF-Prozessen üblicherweise zusätzlicher apparativer Aufwand notwendig, um Generator- und Plasmaimpedanzen durch elektrische Netzwerke, wie beispielsweise eine sogenannte Matchbox, während des Prozesses dynamisch aneinander anzupassen.

Im folgenden werden kurz verschiedene aus dem Stand der Technik bekannte Verfahren bzw. Schichtsysteme angeführt.

Die EP 87 836 offenbart ein DLC-Schichtsystem mit einem 0,1 - 49,1%igen Anteil metallischer Komponenten, welches beispielsweise mittels kathodischem Sputtern abgeschieden wird.

Die DE 43 43 354 A1 beschreibt ein Verfahren zur Herstellung eines mehrlagigen Tihaltigen Schichtsystems mit einer Hartstoffschicht aus Titannitriden Titankarbiden und Titanboriden sowie einer reibmindernden C-haltigen Oberflächenschicht, wobei der Ti- und N-Anteil in Richtung der Oberfläche fortschreitend verringert wird.

Einen gepulsten Plasmastrahl verwendet das in der US 5 078 848 beschriebene Verfahren zur Herstellung von DLC-Schichten. Auf Grund der gerichteten Teilchenstrahlung aus einer Quelle mit geringem Austrittsquerschnitt eignen sich aber solche Verfahren nur bedingt zur gleichmässigen Beschichtung grösserer Flächen.

Verschiedene CVD-Verfahren bzw. mit solchen Verfahren hergestellte SiDLC/DLC Mischschichten werden in den folgenden Dokumenten beschrieben:

Die EP-A-651 069 beschreibt ein reibminderndes Verschleissschutzsystem aus 2 - 5000 alternierenden DLC und SiDLC-Schichten. Ein Verfahren zur Abscheidung von a-DLC-Schichten mit einer Si-Zwischenschicht und daran anschliessender a-SiC:H-Uebergangszone zur Verbesserung der Haftung wird in der EP-A-600 533 beschrieben. Auch in der EP-A-885 983 und der EP-A-856 592 werden verschiedene Verfahren zur Herstellung solcher Schichten beschrieben. In der EP-A-885 983 beispielsweise wird das Plasma durch ein DCbeheiztes Filament erzeugt und die Substrate mit negativer Gleichspannung oder MF zwischen 20 - 10.000 kHz beaufschlagt (als MF = Mittelfrequenz wird im folgenden der Frequenzbereich zwischen 1 und 10.000 kHz verstanden).

Die US 4 728 529 beschreibt eine Methode zur Abscheidung von DLC unter Anwendung eines HF-Plasmas, bei der die Schichtbildung in einem Druckbereich zwischen 103 und 1 mbar aus einem sauerstofffreien Kohlenwasserstoffplasma, dem bei Bedarf Edelgas oder Wasserstoff beigemischt wird, erfolgt.

Der in der DE-C-195 13 614 beschriebene Prozess verwendet eine bipolare Substratspannung mit einer kürzeren positiven Pulsdauer in einem Druckbereich zwischen 50-1000 Pa. Damit werden Schichten im Bereich von 10 nm bis 10 $\mu$m und einer Härte zwischen 15 - 40 GPa abgeschieden.

Ein CVD-Verfahren mit unabhängig vom Beschichtungsplasma erzeugter Substratspannung wird in der DE-A-198 26 259 beschrieben, wobei bevorzugt bipolare, jedoch auch andere periodische veränderte Substratspannungen angelegt werden. Dies bedarf jedoch einer relativ aufwendigen, da in zweifacher Ausführung vorzusehenden, elektrischen Versorgungseinheit zur Durchführung des Verfahrens.

Weiters sind Verfahren aus einer Kombination traditioneller Hartstoffschichten mit einer kohlenstoffreichen Deckschicht mit günstigen Gleiteigenschaften schon länger bekannt. Beispielsweise offenbart US 5,707,748 eine Schichtkombinationen aus metallhaltigen Hartstoffschichten (TiN, TiAlVN, WC) und einer weniger harten Metallkarbidschicht mit zunehmendem Gehalt an graphitisch, d.h. in $sp^2$ Hybridisierung, gebundenem Kohlenstoff. Durch die guten Gleiteigenschaften von Metall/- bzw. Metallkarbid/Kohlenstoffschichten (MeC/C) werden diese bevorzugt in Tribosystemen eingesetzt, wo neben dem Schutz des beschichteten Teils eine Verringerung der Reibungskräfte und/oder ein Schutz des Gegenkörpers bewirkt werden sollen. Besonders wirkungsvoll haben sich diesbezüglich MeC/C-Schichten mit einem hohen C-Anteil erwiese, bei denen durch die weiche Deckschicht einerseits ein Einlaufeffekt, andererseits durch Übertrag von C-Partikeln ein Schmiereffekt für das ganze Tribosystem erreicht werden kann. Ähnliche Schichtkombinationen mit einer die Haftung verbessernden metallischen Zwischenschicht zwischen der Hartstoffschicht und der graphitischen Kohlenstoff enthaltenden Metall- bzw. MeC-Schicht werden in WO 99-55929 beschrieben.

Entsprechend ist es die Aufgabe der vorliegenden Erfindung relativ dicke DLC-Schichtsysteme mit hoher Härte und ausgezeichneter Haftfestigkeit zur Verfügung zu stellen, die ausserdem noch eine genügend hohe Leitfähigkeit besitzen, um ohne HF-Bias abgeschieden werden zu können, so dass ein Verfahren und eine Vorrichtung verwendet werden können, die keinen grossen Aufwand erfordern und eine hohe Effektivität für den industriellen Einsatz aufweisen. Entsprechend ist es auch eine Aufgabe der vorliegenden Erfindung ein entsprechendes Verfahren und eine Vorrichtung bereitzustellen.

Diese Aufgabe wird gelöst durch die Schicht mit den Merkmalen des Anspruchs 1 sowie dem Verfahren nach Anspruch 16 und der Vorrichtung gemäss Anspruch 24. Vorteilhafte Ausgestaltungen sind Gegenstand der Untermerkmalssätze.

Überraschenderweise hat sich weiters gezeigt, dass es möglich ist, auch relativ dicke DLC-Schichten mit einer zusätzlichen Schicht mit besonders günstigen Gleit- und falls erwünscht Einlaufeigenschaften zu versehen, ohne dass dadurch die Haftfestigkeit verschlechtert wird. Dadurch gelingt es erstmals die grosse Härte von reinen DLC-Schichten mit den günstigen Gleiteigenschaften von Metallkohlenstoffschichten zu kombinieren. Dies kann nicht nur durch Aufbringen von Gleitschichten auf erfinderische DLC-Schichtsysteme, sondern auch durch Anwendung eines der beschriebenen Verfahren zur Aufbringung einer Gleitschicht auf bekannte DLC-Schichten bzw. DLC-Schichtsysteme erfolgen.

Aufgabe der vorliegenden Erfindung ist es somit insbesonders auch eine DLC- bzw. eine Diamantschicht mit einer ausgezeichneter Haftfestigkeit und einem hohen Verschleisswiderstand zur Verfügung zu stellen, die gegenüber herkömmlichen DLC- bzw. Diamantschichten verbesserte Gleiteigenschaften und falls erwünscht Einlaufeigenschaften aufweist. Eine solche DLC-Gleitschichtsystem kann für den Verschleissschutz, den Korrosionsschutz und zur Verbesserung der Gleiteigenschaften von Vorteil sein, insbesonders dann, wenn bis jetzt schwer in einem Schichtsystem zu verwirklichende Eigenschaften gleichzeitig erwünscht sind.

Eine weitere Aufgabe der Erfindung ist es ein Verfahren und eine Vorrichtung zur Herstellung eines erfindungemässen DLC-Gleitschichtsystems zu Verfügung zu stellen.

Dies wird erfindungsgemäss nach Absatz 1 der Beschreibung gelöst.

## SCHICHTSYSTEM

Ein erfindungsgemässes **DLC-Schichtsystem** wird durch Herstellen einer Schicht mit dem Schichtaufbau gemäß Anspruch 1 erreicht.

Direkt auf dem Substrat befindet sich eine Haftschicht mit mindestens einem Element aus der Gruppe der Elemente der IV, V und VI Nebengruppe sowie Si. Laut Anspruch 1 wird eine Haftschicht aus den Elementen Cr oder Ti verwendet, die sich für diesen Zweck als besonders geeignet erwiesen haben.

Daran schliesst sich eine Uebergansschicht an, die vorzugsweise als Gradientenschicht ausgebildet ist, in deren Verlauf senkrecht zur Substratoberfläche der Metallgehalt ab - und der C-Gehalt zunimmt.

Die Uebergangsschicht umfasst im wesentlichen Kohlenstoff und mindestens ein Element aus der Gruppe der Elemente, die die Haftschicht bilden. Zusätzlich kann bei einer bevorzugten Ausführungsform Wasserstoff enthalten sein. Darüber hinaus beinhalten sowohl die Uebergangsschicht als auch die Haftschicht unvermeidbare Verunreinigungen, wie sie beispielsweise durch in die Schicht eingebaute Atome aus der umgebenden Atmosphäre gegeben sind, beispielsweise die bei der Herstellung verwendeten Edelgase, wie Argon oder Xenon.

Bei der Ausbildung der Uebergangsschicht in Form einer Gradientenschicht kann der Zuwachs des Kohlenstoffs in Richtung der Deckschicht durch Zunahme gegebenenfalls unterschiedlicher karbidischer Phasen, durch Zunahme des freien Kohlenstoffs, bzw. durch eine Mischung derartiger Phasen mit der metallischen Phase der Uebergangsschicht erfolgen. Die Dicke der Gradienten- bzw. Uebergangsschicht kann dabei, wie dem Fachmann bekannt, durch Einstellung geeigneter Prozessrampen eingestellt werden. Die Zunahme des C-Gehalt bzw. Abnahme der metallischen Phase kann kontinuierlich oder stufenweise erfolgen, ferner kann zumindest in einem Teil der Uebergangsschicht auch eine Abfolge metallreicher und C-reicher Einzelschichten zum weiteren Abbau von Schichtspannungen vorgesehen werden. Durch die erwähnten Ausbildungen der Gradientenschicht werden die Materialeigenschaften (beispielsweise E-Modul, Struktur etc.) der Haft- und der abschliessenden DLC-Schicht im wesentlichen kontinuierlich aneinander angepasst und damit der Gefahr der Rissbildung entlang einer sonst auftretenden Metall bzw. Si /DLC-Grenzfläche entgegengewirkt.

Den Abschluss des Schichtpakets bildet eine im wesentlichen ausschliesslich aus Kohlenstoff und vorzugsweise Wasserstoff bestehende Schicht, mit einer im Vergleich zur Haft- und Uebergansschicht grösseren Schichtdicke. Zusätzlich zum Kohlenstoff und Wasserstoff können auch hier Edelgase, wie Argon oder Xenon vorkommen. Wesentlich ist hier jedoch, dass auf zusätzliche metallische Elemente oder Silizium vollständig verzichtet wird.

Die Härte des gesamten DLC-Schichtsystems ist auf einen Wert grösser 15 GPa, bevorzugt grösser/gleich 20 GPa eingestellt und eine Haftfestigkeit besser oder gleich HF 3, bevorzugt besser oder gleich HF 2, insbesondere gleich HF 1 nach VDI 3824 Blatt 4 wird erreicht. Die Härte wird hierbei über die Knoop Härtemessung mit o,1 N Last, d.h. HK0,1 entsprechen. Der Oberflächenwiderstand der DLC-Schicht liegt zwischen $\delta = 10^{-6}\Omega$ und $\delta = 5M\Omega$, bevorzugt zwischen $1\Omega$ und 500 k$\Omega$, bei einem Elektrodenabstand von 20 mm. Gleichzeitig zeichnet sich die vorliegende DLC-Schicht durch die für DLC typische niedrige Reibkoeffizienten, bevorzugt $\mu \leq 0.3$ im Stift / Scheibetest, aus.

Die Schichtdicken sind insgesamt > 1 $\mu$m, vorzugsweise > 2 $\mu$m, wobei die Haftschicht und die Uebergangsschicht vorzugsweise Schichtdicken von 0.05 $\mu$m bis 1,5 $\mu$m, insbesondere von 0,1 $\mu$m bis 0,8 $\mu$m aufweisen, während die Deckschicht laut Anspruch 1 eine Dicke von 0,5 $\mu$m bis 20 $\mu$m, insbesondere 1 $\mu$m bis 10 $\mu$m hat.

Der H-Gehalt ist in der Deckschicht vorzugsweise 5 bis 30 Atom%, insbesondere 10 - 20 Atom%.

In REM-Aufnahmen zeigen erfindungsgemässe abgeschiedene DLC-Schichtsysteme Bruchfläche, die im Gegensatz zu herkömmlichen DLC-Schichten, keine glasig-amorphe sondern eine feinkörnige Struktur aufweisen, wobei die Komgrösse bevorzugt $\leq$ 300 nm, insbesondere $\leq$ 100 nm beträgt.

In tribologischen Tests unter hoher Belastung zeigt die Beschichtung eine vielfache Lebensdauer gegenüber anderen DLC-Schichten, wie beispielsweise Metallkohlenstoff-, insbesondere WC/C-Schichten. So konnte auf einer mit einer DLC-Schicht versehenen Einspritzdüse für Verbrennungsmotoren im Test nach 1000h nur ein geringfügiger Verschleiss festgestellt werden, wohingegen im selben Test eine mit WC/C beschichtete Düse bereits nach 10h auf Grund eines hohen Oberflächenverschleisses bis in den Grundwerkstoff ausfiel.

Die Schichtrauhigkeit der erfindungsgemässen DLC-Schicht hat vorzugsweise einen Wert von Ra=0.01-0.04;

wobei Rz nach DIN gemessen < 0.8 bevorzugt < 0.5 ist.

Die Vorteile eines erfindungsgemässen DLC-Schichtsystems mit obigen Eigenschaften liegen in der erstmals gelungenen Kombination von grossen Schichtdicken mit ausgezeichneter Haftfestigkeit, die noch eine ausreichende Leitfähigkeit aufweisen, um eine verhältnismässig einfache Prozessführung in der industriellen Produktion zu ermöglichen.

Trotz der hohen Härte von > 15 GPa, bevorzugt $\geq$ 20 GPa zeigt die Schicht auf Grund ihrer Struktur und der erfindungsgemässen Verfahrensschritte eine deutlich verbesserte Haftung. Herkömmliche Schichtsysteme benötigen hier eine Dotierung in der Funktionsschicht (DLC), um die Schichtspannung zu reduzieren, was aber auch die Härte reduziert.

Auch REM-Bruchbilder der erfindungsgemässen Schicht zeigen im Gegensatz zu bisher bekannten DLC-Schichten, die die typische Bruchform einer amorphen spröden Schicht mit teils muscheligen Ausbrüchen besitzen, eine feinkörnige gerade Bruchfläche. Schichten mit dem oben beschriebenen Eigenschaftsprofil eignen sich besonders für Anwendungen im Maschinenbau wie zum Beispiel zur Beschichtung von hochbelasteten Pumpen- bzw. Tassenstösseln und Ventiltrieben, Nocken bzw. Nockenwellen wie sie für Kfz-Verbrennungsmotoren und Getriebe verwendet werden, aber auch für den Schutz von hochbelasteten Zahnrädern, Plungern, Pumpenspindeln u.a. Bauteilen bei denen eine besonders harte und glatte Oberfläche mit guten Gleiteigenschaften benötigt wird.

Im Werkzeugbereich können dies Schichten auf Grund ihrer hohen Härte und sehr glatten Oberfläche vorteilhaft vor allem für Umform- (Pressen, Stanzen, Tiefziehen, ...) und Spritzgusswerkzeuge, jedoch auch, mit gewissen Einschränkungen bei der Bearbeitung von Eisenwerkstoffen, für Schneidwerkzeuge eingesetzt werden, insbesondere wenn für die Anwendung ein geringer Reibkoeffizient gepaart mit einer hohen Härte notwendig ist.

Die Wachstumsgeschwindigkeit der DLC-Schicht liegt bei etwa 1-3 $\mu$m/h, die Schichtspannung für das ganze System bei 1-4 GPa und somit im üblichen Bereich von harten DLC-Schichten. Die Leitfähigkeit wird auf Grund der obiger Ausführungen etwa zwischen $\delta = 10^{-6}\,\Omega$ und $\delta = 5\,M\Omega$, bevorzugt zwischen $\delta = 10^{-3}\,\Omega$ und $\delta = 500\,k\Omega$ eingestellt (gemessen wurde hierbei der Oberflächenwiderstand bei einem Abstand der Messelektroden von 20 mm).

Die mit erfindungsgemäss abgeschiedenen DLC-Schichtsystemen erreichten Gleiteigenschaften sind zwar günstiger als die anderer beispielsweise nitridischer und/oder karbidischer Hartstoffschichten, erreichen aber weder die ausserordentlich kleinen Reibkoeffizienten die sich mit Metall/Kohlenstoffschichten verwirklichen lassen, noch sind sie als Einlaufschichten geeignet.

Sollen die Gleit- bzw. Einlaufeigenschaften der DLC-Schicht bzw. des DLC-Schichtsystems weiter verbessert werden, so empfiehlt es sich noch eine abschliessende weichere, einen relativ grossen Anteil an graphitischen Kohlenstoff enthaltende Gleitschicht aufzubringen. Letztere kann auch vorteilhaft auf nicht erfinderische DLC-Schichten und -Schichtsysteme sowie auf Diamanschichten, insbesonders auf nanokirstalline Diamantschichten, aufgebracht werden.

Im Folgenden wird der Aufbau eines erfindungsgemässen **DLC-Gleitschichtsystems** beschrieben, das vorteilhafterweise, jedoch keinesfalls einschränkend, aus einem wie oben beschriebenen DLC-Schichtsystem mit einer darauf abgelegten Gleitschicht besteht. Überraschenderweise hat sich sezeigt, dass es mit sehr unterschiedlich aufgebauten Gleitschichten möglich ist neben der Verbesserung der Gleit- und eventuell Einlaufeigenschaften, trotz der erhöhten Schichtdicke die ausgezeichnete Haftfestigkeit des DLC-Schichtsystems für das DLC-Gleitschichtsystem zu erhalten.

Eine, insbesondere zur Anwendung auf oben beschriebene erfinderische DLC-Schichtsystem besonders geeignete, vorteilhafte Ausführungsform der reibmindernden Schicht besteht darin eine DLC-Struktur, ohne metallischem Zusatzelement, dafür aber mit zunehmendem Anteil an $sp^2$-Bindungen, bevorzugt in graphitischer Schichtstruktur aufzubringen, womit die Härte der Deckschicht herabgesetzt, sowie die Gleit- und gegebenenfalls Einlaufeigenschaften verbessert werden.

Eine andere vorteilhafte Ausführung der Gleitchicht kann durch Ausbildung einer zweiten, inversen Gradientenschicht erfolgen, bei der der Metallgehalt zur Oberfläche zu, der C-Gehalt aber abnimmt. Dabei wird der Metallgehalt solange erhöht, bis der Reibkoeffizient einen gewünschten niedrigen Wert erreicht. Bevorzugt wird dazu ein oder mehrere Metalle aus der IV, V, VI Nebengruppe, sowie Si verwendet. Besonders bevorzugt Cr, W, Ta, Nb und/oder Si. Der Metallanteil der Schichten sollte dabei zwischen 0.1 und 50 atom%, bevorzugt zwischen 1 und 20 atom% liegen.

Eine weitere bevorzugte Ausführung der reibmindernden Schicht kann durch Aufbringen einer metallischen bzw. karbidischen, insbesonders einer Cr- oder WC-Zwischenschicht, auf die im wesentlichen ausschliesslich aus Kohlenstoff und Wasserstoff bestehende Schicht, hergestellt werden, wobei anschliessend wiederum eine ähnlich der ersten Gradientenschicht ausgebildete Gradientendeckschicht mit abnehmendem Metall- und zunehmenden C-Gehalt folgt. Vorteilhafter- aber nicht zwingender Weise wird dabei dasselbe oder dieselben metallischen Elemente wie in der ersten Gradientenschicht verwendet um die Komplexität der Beschichtungsvorrichtung möglichst gering zu halten. Auch hier sollte der Metallanteil der Schichten dabei zwischen 0.1 und 50 atom%, bevorzugt zwischen 1 und 20 atom% liegen.

Überraschenderweise hat sich gezeigt, dass gerade metallhaltige Gleitschichten auch auf herkömmlich abgeschiedenen DLC-Schichten eine deutliche Verbesserung der Peformance bewirken können. Ein Grund für den damit erzielten geringen Einfluss auf die Gesamthaftung solcher Systeme könnte auf die gut einstellbaren, geringen zusätzlich eingebrachten Schichtspannungen zurückzuführen sein.

Für alle drei Möglichkeiten hat es sich als vorteilhaft erwiesen, einen abschliessenden Bereich mit unveränderter d.h. konstanter Schichtzusammensetzung vorzusehen, um die auf die jeweilige Anwendung optimierten Eigenschaften der Schicht (z.B. Reibbeiwert, Oberflächenspannung und Benetzbarkeit, ...) auch über einen gewissen Schichtverschleiss aufrecht zu erhalten und ein Einlaufen der Schicht zu ermöglichen.

Der Reibbeiwert kann je nach verwendetem Metall und verbleibendem Überschuss an gaphitischem Kohlenstoff zwischen $\mu = 0.01$ und $\mu = 0.2$ eingestellt werden (bezieht sich auf Stift / Scheibetest unter Normalatmosphäre mit ca. 50% Luftfeuchte).

Die Härte der DLC-Schicht ist bevorzugt auf einen Wert grösser 15 GPa, bevorzugt grösser/gleich 20 GPa eingestellt, die Härte der darüberliegenden weicheren Gleitschicht wird je nach Bedarf eingestellt.

Der integrale Wasserstoffgehalt des erfindungsgemässen Schichtsystems wird bevorzugt auf einen Gehalt zwischen 5-30 Atom% insbesonders zwischen 10-20 Atom% eingestellt.

Die Schichtrauhigkeit kann auf einen Ra-Wert von unter 0.04 bevorzugt unter 0.01, bzw. einen $Rz_{DIN}$-Wert von kleiner 0.8 bevorzugt kleiner 0.5 eingestellt werden.

Die Vorteile solcher erfindungsgemässer DLC-Gleitschichtsystems liegen in der Kombination der grossen Härte der DLC-Schicht, gepaart mit einer gegenüber den bereits guten Laufverhalten der DLC-Schicht nochmals um bis zu einer Grössenordnung verbesserten Gleiteigenschaften. So kann beispielsweise der Reibkoeffizient damit unter $\mu = 0.1$ gesenkt werden. Weiters gelingt es damit erstmals auch DLC-Schichten ein Einlaufverhalten durch anfänglichen Schichtabtrag und graphitische Gegenkörperschmierung zu verleihen, wodurch auch der Verschleiss eines unbeschichteten Gegenörpers deutlich verringert werden kann.

Weiters kann durch Verwendung einer oben beschriebenen reinen DLC-Schicht eine niedrigere Rz- bzw. Ra-Zahl, d.h. eine geringere Rauhigkeit der beschichteten Oberflächen, als mit herkömmlich verwendeten Hartstoffschichten, insbesonders mit dem Arc-Verfahren aufgebrachten, eingestellt werden. Bei solchen bekannten Hartstoff / Gleitschichtkombinationen kann durch insbesonders harte Rauhigkeitsspitzen häufig das Einlaufen des Tribosystems gestört, wenn nicht sogar verhindert und werden, wodurch es zur teilweisen oder gänzlichen Zerstörung der Oberfläche eines Gegenkörpers kommen kann, insbesonders wenn dieser nicht selbst durch eine Hartschicht geschützt ist. Dies ist besonders in Tribosystemen mit hohem Gleitanteil, wie zum Beispiel Kipp- und Gleithebel auf Tassenstössel, unterschiedliche Verzahnungen u.a. von Bedeutung.

Die Überlegenheit von DLC-Gleitschichtsystemen zeigte sich hier in verschiedenen Anwendungen sowohl gegenüber bekannten Hartstoff / Gleitschichtkombinationen als auch gegenüber reinen DLC-Schichtsystemen.

Auch im Werkzeugbereich können dies Schichten auf Grund ihrer hohen Härte und sehr glatten Oberfläche vorteilhaft vor allem für Umform- (Pressen, Stanzen, Tiefziehen, ...) und Spritzgusswerkzeuge, jedoch auch mit gewissen Einschränkungen bei der Bearbeitung von Eisenwerkstoffen für Schneidwerkzeuge eingesetzt werden, insbesondere wenn für die Anwendung ein besonders geringer Reibkoeffizient eventuell gepaart mit einem definiertem Einlaufeffekt gewünscht wird. Beispielsweise wurde mit erfindunggemäss beschichteten Bohrern bereits nach einmaligem Einsatz (ein Bohrloch) ein Poliereffekt auf der Spanablauffläche beobachtet, was beispielsweise für Tieflochbohrungen von Vorteil ist. So kann bei derartigen erfindungsgemäss beschichteten Werkzeugen auf ein teures Nachpolieren der Spanablaufflächen verzichtet werden.

Erfindungsgemässe DLC-Gleitschichtsysteme können glatter als herkömmliche beispielsweise mit Lichtbogenverdampfern abgeschieden Hartstoff / Gleitschichtkombinationen (z.B. TiAlN/ /WC/C) abgeschieden und einfacher, in einem durchlaufenden Prozess integriert werden als beispielsweise ebenfalls bekannte Ti-DLC // MoSx-Schichtkombinationen.


**VERFAHREN**


Das erfindungsgemässe Verfahren zur Herstellung des DLC-Schichtsystems zeichnet sich weiterhin durch die Merkmale gemäß Anspruch 16 aus.

Die zu beschichtenden Teile werden in einer für PVD-Verfahren bekannten Weise gereinigt und auf einer Halterungsvorrichtung montiert. Im Gegensatz zu HF-Verfahren können dabei vorteilhafterweise Halterungsvorrichtungen mit - je nach Teilchengeometrie angepasst - 1, 2 oder auch 3 im wesentlichen parallelen Rotationsachsen verwendet werden, wodurch eine grössere Beladungsdichte erzielt werden kann. Die Halterungsvorrichtung mit den zu beschichtenden Teilen wird in die Prozesskammer einer Beschichtungsanlage gebracht und nach Abpumpen auf einen Startdruck von weniger als 10-4 mbar, vorzugsweise 10-5 mbar wird die Prozessfolge gestartet.

Der erste Teil des Prozesses, das Reinigen der Substratoberflächen, wird beispielsweise als Heizprozess durchgeführt, um die noch an der Oberfläche der Teile anhaftenden flüchtigen Substanzen zu entfernen. Dazu wird bevorzugt ein Edelgas -Plasma mittels einer Hochstrom/Niedervoltentladung zwischen einem oder mehreren, in einer an die Prozesskammer angrenzenden Ionisationskammer angeordneten, auf negatives Potential gelegten Filamenten und den auf positives Potential gelegten Halterungsvorrichtungen mit den Teilen gezündet. Dadurch wird ein intensiver Elektronenbeschuss und damit ein Erwärmen der Teile bewirkt. Als besonders günstig hat sich dabei die Verwendung eines Ar/H2-Gemisches erwiesen, da hierbei durch die reduzierende Wirkung des Wasserstoffs gleichzeitig ein Reinigungseffekt der Teileoberflächen erzielt wird. Die Hochstrom/Niedervoltbogenentladung kann dabei mit einem statischen oder vorteilhafterweise im wesentlichen örtlich variabel bewegten magnetischen Feld geführt werden. Statt der oben beschrieben Ionisationskammer kann auch eine Hohlkathode oder eine andere bekannte Ionen- bzw. Elektronenquelle benutzt werden.

Alternativ können natürlich auch andere Heizverfahren wie z.B. Strahlungsheizen oder induktives Heizen verwendet werden.

Nach Erreichen eines, je nach Grundwerkstoff der Teile festzulegenden Termperatumiveaus, kann zusätzlich oder alternativ als Reinigungsprozess ein Aetzprozess gestartet werden, indem beispielsweise zwischen Ionisationskammer und einer Hilfsanode ein Niedervoltbogen gezündet wird, und die Ionen mittels einer negativen Biasspannung von 50-300 V auf die Teile gezogen werden. Die Ionen bombardieren dort die Oberfläche und entfernen restliche Verunreinigungen. Somit wird eine saubere Oberfläche erzielt. Die Prozessatmosphäre kann neben Edelgasen, wie z.B. Argon auch Wasserstoff enthalten.

Ferner kann der Aetzprozess auch durch Anlegen einer gepulsten Substratbiasspannung ohne oder mit Unterstützung durch einen, wie soeben beschriebenen Niedervoltbogen erfolgen, wobei vorzugsweise ein Mittelfrequenzbias im Bereich von 1 bis 10.000 kHz, insbesondere zwischen 20 und 250 kHz verwendet wird.

Um die Haftung des DLC-Schichtsystems auf dem Substrat zu gewährleisten, wird eine bevorzugt metallische, insbesondere aus Cr oder Ti bestehende Haftschicht mit einem bekannten PVD bzw. Plasma-CVD Verfahren, wie beispielsweise mittels Arcverdampfen, verschiedenen Ionplatingverfahren, bevorzugt jedoch durch kathodisches Sputtern mindestens eines Targets aufgedampft. Zur Unterstützung des Aufdampfens wird am Substrat eine negative Substratbiasspannung angelegt. Der Ionenbeschuss und die damit bewirkte Schichtverdichtung während des Sputterprozesses kann zusätzlich durch einen parallel betriebenen Niedervoltbogen und/oder ein zur Stabilisierung bzw. Intensivierung des Plasmas angelegtes Magnetfeld, und/oder durch das Anlegen einer DC-Biasspannung am Substrat oder durch das Anlegen eines Mittelfrequenzbias zwischen Substrat und Prozesskammer im Bereich von 1 bis 10.000, insbesondere zwischen 20 bis 250 kHz unterstützt werden.

Die Dicke der Haftschicht wird in bekannter Weise durch eine der jeweiligen Anlagengeometrie entsprechenden Wahl der Sputter- bzw. Aufdampfzeit und Leistung eingestellt.

Beispielsweise wird bei vorliegender, wie unten beschriebenen, Anlagengeometrie Cr für die Dauer von 6 Minuten von zwei vorteilhafterweise gegenüberliegenden Targets bei einem Druck zwischen 10-4 bis 10-3 mbar, einem Substratbias von Ubias = -75 V und einer Leistung von ca. 8 kW in einer Ar-Atmosphäre gesputtert. Nach Aufbringen der Haftschicht wird erfindungsgemäss durch Aufbringen einer Uebergangsschicht ein möglichst fliessender Übergang zwischen Haftschicht und DLC-Schicht sichergestellt.

Das Aufbringen der Uebergangsschicht erfolgt so, dass neben dem plasmagestützten Aufdampfen der Haftschichtkomponenten zeitgleich Kohlenstoff aus der Gasphase abgeschieden wird. Dies erfolgt vorzugsweise über ein Plasma-CVD-Verfahren, bei dem ein kohlenstoffhaltiges Gas, vorzugsweise ein Kohlenwasserstoffgas, insbesondere Acetylen als Reaktionsgas verwendet wird.

Während des Aufbringens der Uebergangsschicht wird am Substrat eine insbesondere "gepulste", mittelfrequente Substratbiasspannung angelegt und ein Magnetfeld überlagert.

Zur bevorzugten Ausbildung einer Gradientenschicht wird während des Aufbringens der Uebergangsschicht der Anteil der Kohlenstoffabscheidung mit zunehmender Dicke der Uebergangsschicht schrittweise oder kontinuierlich erhöht, bis letztendlich im wesentlichen nur noch eine Kohlenstoffabscheidung stattfindet.

In diesem Prozessstadium wird dann als Deckschicht die diamantähnliche Kohlenstoffschicht durch Plasma-CVD-Abscheidung von Kohlenstoff aus der Gasphase erzeugt, wobei als Reaktionsgas ein kohlenstoffhaltiges Gas, vorzugsweise ein Kohlenstoffwassergas, insbesondere Acetylen verwendet wird. Gleichzeitig wird am Substrat weiterhin eine Substratbiasspannung beibehalten und das überlagerte Magnetfeld aufrechterhalten.

Bei einer bevorzugten Ausführungsform kann das Reaktionsgas zur Abscheidung von Kohlenstoff zur Bildung der Uebergangsschicht und der Deckschicht aus diamantähnlichem Kohlenstoff neben dem kohlenstoffhaltigen Gas zusätzlich Wasserstoff und Edelgas, vorzugsweise Argon oder Xenon, beinhalten. Der eingestellte Druck in der Prozesskammer beträgt dabei zwischen 10-4 bis 10-2 mbar.

Während des Abscheidens der Deckschicht aus diamantähnlichem Kohlenstoff ist es bevorzugt den Anteil des kohlenstoffhaltigen Gases zu erhöhen und den Anteil an Edelgas, insbesondere Argon zu senken.

Die während der Verfahrensschritte zum Aufdampfen der Haftschicht, Aufbringen der Uebergangsschicht und Abscheiden der Deckschicht am Substrat angelegte Substratbiasspannung kann insbesondere bei der Bildung der Uebergangsschicht und der Deckschicht eine Wechselspannung (AC), eine mit AC oder Puls überlagerte Gleichspannung (DC) bzw. modulierte Gleichspannung sein, wie insbesondere eine unipolare (negative) oder bipolare Substratbiasspannung sein, die in einem Mittelfrequenzbereich von 1 bis 10000 kHz, vorzugsweise 20 bis 250 kHz gepulst ist. Die Pulsform kann dabei symmetrisch beispielsweise sinus-, sägezahn-, oder rechteckförmig sein oder asymmetrisch, so dass lange negative und kurze positive Impulszeiten oder grosse negative und kleine positive Amplituden angelegt werden.

Darüber hinaus wird vorzugsweise während des gesamten Beschichtungsprozesses ein longitudinales Magnetfeld mit gleichmässigen Feldlinienverlauf eingestellt, wobei das Magnetfeld seitlich und/oder räumlich, kontinuierlich oder schrittweise veränderbar ist.

Vorzugsweise wird, falls für das Aufbringen der Haftschicht ein DC-Bias verwendet wurde, beim Aufbringen der Uebergangsschicht, zunächst an die Halterungsvorrichtung ein Mittelfrequenzgenerator angeschlossen, der seine Sapnnungsimpulse (Regelung über Steuerung der eingebrachten Leistung ist ebenfalls möglich, aber nicht bevorzugt) in Form eines sinus-, oder eines anderen bi- bzw. auch unipolaren Signalverlaufs abgibt. Der verwendete Frequenzbereich liegt hierbei zwischen 1 bis ca. 10.000 kHz, bevorzugt zwischen 20 und 250 kHz, die Amplitudenspannung zwischen 100 und 3.000 V, bevorzugt zwischen 500 und 2.500 V. Vorzugsweise wird der Wechsel der Substratspannung durch Umschalten eines eigens zur Abgabe von Gleich- und Mittelfrequenzspannung ausgelegten Generators durchgeführt. In einer anderen vorteilhaften Ausführungsform wird auch für die Durchführung des Aetz- und Haftbeschichtungsprozesses eine Mittelfrequenzspannung an die Substrate angelegt. Bei Verwendung eine bipolaren Substratspannung hat es sich als besonders vorteilhaft erwiesen asymmetrische Itnpulsformen anzulegen, beispielsweise kann der positive Impuls entweder kürzer oder mit einer kleineren Spannung als der negative Impuls angelegt wird, da die Elektronen rascher dem Feld folgen und auf Grund Ihrer geringen Masse beim Auftreffen vor allem zu einer zusätzlichen Erwärmung der Teile führen, was besonders bei temperaturempfindlichen Grundwerkstoffen zu einer Schädigung durch Überhitzung führen kann. Dieser Gefahr kann auch bei anderen Signalverläufen durch Vorsehen einer sogenannten "OFF-Time" entgegengewirkt werden, bei der zwischen dem Anlegen einzelner oder mehrerer Signalperioden mit Leistungsanteil (= "ON-Time") ein Nullsignal angelegt wird.

Zeitgleich oder mit einer zeitlichen Verzögerung nach Anlegen des Mittelfrequenzsignals, bei Verwendung eines DC-Bias zum Aufbringen der Haftschicht, bzw. nach Aufdampfen der für die Haftschicht gewünschten Schichtdicke bei Verwendung eines Mittelfrequenzbias, wird eine Kohlenwasserstoffgas, bevorzugt Acetylen mit einem schrittweise oder bevorzugt kontinuierlich ansteigenden Gasfluss in den Rezipienten eingelassen. Ebenso zeitgleich oder mit einer gegebenenfalls unterschiedlichen zeitlichen Verzögerung wird vorzugsweise die Leistung des mindestens einen metallischen oder Si-Targets schrittweise oder kontinuierlich heruntergefahren. Bevorzugt wird dabei das Target bis zu einer, je nach erreichtem Kohlenwasserstofffluss von einem Fachmann leicht zu bestimmenden Mindestleistung heruntergefahren, bei der noch ein stabiler Betrieb ohne Vergiflungserscheinungen durch das Reaktivgas möglich ist. Anschliessend wird das mindestens eine Target bevorzugt mit einer oder mehreren beweglich angeordneten Blenden gegen die Prozesskammer abgeschirmt, und abgeschaltet. Diese Massnahme verhindert weitgehend eine Belegung des Targets mit einer DLC-Schicht, womit auf ein sonst notwendiges Freisputtern zwischen einzelnen DLC-Beschichtungschargen verzichtet werden kann. Bei der nächsten durchzuführenden Charge genügt es ein Hochfahren des mindestens einen Targets bei geschlossenen Blenden vorzusehen, um wieder eine völlig blanke, für das Aufbringen der Haftschicht geeignete Targetoberfläche zu erzielen.

Ein wesentlicher Beitrag zur Stabilisierung des erfindungsgemässen DLC-Beschichtungsprozesses wird durch das Ausbilden eines longitudinalen Magnetfeldes erreicht. Dieses wird - wenn nicht schon im vorhergehenden Prozessschritt zum Aufbringen der Haftschicht verwendet - im wesentlichen zeitgleich mit dem Umschalten der Substratspannung auf den Mittelfrequenzgenerator erfolgen. Das Magnetfeld wird so ausgebildet, dass ein möglichst, gleichmässiger Feldlinienverlauf in der Prozesskammer gegeben ist. Dazu wird bevorzugt durch zwei im wesentlichen die Prozesskammer an gegenüberliegenden Seiten begrenzende elektromagnetische Spulen Strom so eingeleitet, dass an beiden Spulen ein gleichsinnig gerichtetes, sich gegenseitig verstärkendes Magnetfeld entsteht. Bei kleineren Kammerabmessungen kann eine ausreichende Wirkung gegebenenfalls auch mit nur einer Spule erzielt werden. Damit wird eine annähernd gleichmässige Verteilung des Mittelfrequenzplasmas über grössere Kammervolumen erreicht. Trotzdem kann es durch unterschiedliche Geometrien der zu beschichtenden Teile bzw. der Halterungsvorrichtungen immer noch vereinzelt zur Ausbildung von Nebenplasmen kommen, wenn bestimmte geometrische und elektromagnetische Randbedingungen erfüllt sind. Dem kann durch ein zeitlich und räumlich veränderbares Magnetfeld entgegengewirkt werden, indem die Spulenströme miteinander oder bevorzugt gegeneinander verschoben werden. Beispielsweise wird die erste Spule zunächst während 120 Sekunden durch eine stärkere Stromstärke I durchflossen als die zweite Spule. Während den darauf folgenden 90 Sekunden ist die Stromstärke invers, d.h. das zweite Magnetfeld ist stärker als das erste Magnetfeld. Diese Magnetfeldeinstellungen können periodisch, wie beschrieben, stufenweise oder kontinuierlich vorgenommen werden und damit durch geeignete Wahl der entsprechenden Spulenströme die Ausbildung von stabilen Nebenplasmen vermieden werden.

Erst durch die Verwendung des Magnetfelds und der dadurch erreichten signifikanten Erhöhung der Plasmaintensität ist im Gegensatz zum Stand der Technik möglich auch in niedrigen Druckbereichen von beispielsweise $10^{-3}$ bis $10^{-2}$ mbar einen stabilen CVD-Prozess zur Abscheidung von reinen DLC-Schichten mit hohen Abscheideraten im Bereich von 0,5 bis 5, bevorzugt zwischen 1 - 4 $\mu$m/h zu erzielen. Neben dem Substratstrom ist dabei auch die Plasmaintensität direkt proportional zur Aktivierung des Magnetfeldes. Beide Parameter hängen zusätzlich von der Grösse der angebotenen, mit einem Bias beaufschlagten Flächen ab. Durch die Anwendung niedriger Prozessdrücke können glattere Schichten, mit einer geringeren Anzahl von Wachstumsfehlem sowie geringerer Verunreinigung durch störende Fremdelemente, abgeschieden werden.

Die Wachstumsgeschwindigkeit hängt neben den Prozessparametern auch von der Beladung und der Halterung ab. Insbesondere wirkt sich hierbei aus ob die zu beschichtenden Teile 1-, 2- oder dreifach drehend, auf Magnethalterungen, oder geklemmt bzw. gesteckt befestigt werden. Auch die Gesamtmasse und Plasmadurchgängikeit der Halterungen ist von Bedeutung, so werden beispielsweise mit leichtgebauten Halterungen, z.B. durch Verwendung von Speichentellern, statt Tellern aus Vollmaterial, höhere Wachstumsgeschwindigkeiten und eine insgesamt bessere Schichtqualität erzielt.

Zur weiteren Erhöhung des plasmaverstärkenden Magnetfelds können zusätzlich zu dem longitudinalen, die gesamte Prozesskammer durchdringenden Magnetfeld (Fernfeld) weitere lokale Magnetfelder - sogenannte Nahfelder - vorgesehen werden. Besonders vorteilhaft ist dabei eine Anordnung bei der zusätzlich zu mindesten einem Magnetronmagnetsystem des mindestens einen Targets weitere bevorzugt permanente Magnetsysteme an den die Plasmakammer begrenzenden Wänden angebracht werden, die eine ähnliche oder die gleiche magnetische Wirkung wie das mindesten eine Magnetronmagnetsystem haben. Dabei kann entweder bei allen Magnetron- und weiteren Magnetsystemen derselbe Aufbau oder aber bevorzugt eine Umkehrung der Polungen vorgenommen werden. Dadurch ist es möglich die einzelnen Nahfelder der Magnet- bzw. Magnetronmagnetsysteme gleichsam als einen die Prozesskammer umgebenden magnetischen Einschluss auszubilden um somit eine Absorption der freien Elektronen an den Wänden der Prozesskammer zu verhindern.

Erst durch eine Kombination der wesentlichen Merkmale des erfinderischen Verfahrens ist es möglich, eine wie oben beschriebene Schicht herzustellen. Erst der Einsatz von durch Magnetfelder stabilisierten Plasmen sowie der abgestimmte Einsatz der Substratbiasspannung ermöglicht die Verwendung der für übliche PVD-Prozesse optimierten Halterungen mit hoher Packungsdichte und Prozesssicherheit. Das Verfahren zeigt, wie der Ablauf bzw. die Kombination von Gleichstrom- und Mittelfrequenzplasmen in optimaler Weise für die Abscheidung einer DLC-Schicht eingesetzt werden kann.

Zum Aufbau der unterschiedlichen Gleitschichten werden verschiedene Verfahren angewandt.

Zum Abscheiden einer **graphitisierten DLC-Schicht** wird nach Aufbringen der reinen DLC-Schicht, bei sonst im wesentlichen gleich oder ähnlich eingestellten Prozessparametem, die Biaspannung entweder stufenweise oder kontinuierlich auf einen Wert über 2000 V, vorzugsweise zwischen 2000 und 2500 V eingestellt. Mit steigender Spannung wächst dabei der Anteil der in graphitischer $sp^2$-Bindung aufwachsenden C-Atome. Damit können, in besonders einfacher Weise, der davor abgeschiedenen reinen DLC-Schicht verbesserte Gleiteigenschaften verliehen werden.

Zum Aufbringen einer **inverse Gradientenschicht** gibt es unterschiedliche Möglichkeiten. Im einfachsten Fall kann der Prozess zunächst unter Beibehaltung derselben Paramter wie bei der vorhergehenden DLC-Schicht unter Zuschalten eines oder mehrere metallischen, bzw. metallkarbidischen. Als vorteilhaft hat es sich jedoch erwiesen, zunächst entweder den Kohlenwasserstoffanteil im Gasfluss zu erniedrigen, den Edelgasanteil zu erhöhen oder beide Massnahmen gemeinsam durchzuführen, um ein Vergiften der Targets und damit instabile Prozesszustände zu vermeiden. Weiters kann ein Anfahren der Targets hinter zunächst geschlossenen Blenden von Vorteil sein um eventuelle Dropplets auf den Substraten zu vermeiden. Anschliessend wird die Leistung des mindestens einen Targets stufenweise oder bevorzugt kontinuierlich bis auf einen Wert erhöht, bei dem die Schicht bestimmte erwünschte Schichteigenschaften (Reibbeiwert, ...) aufweist. Die übrigen Parameter werden bevorzugt unverändert belassen, jedoch ist eine zusätzliche Anpassung falls gewünscht jederzeit möglich. Anschliessend wird der Prozess noch bevorzugt unter Konstanthaltung der Einstellung zu Ende geführt, bis eine gewünschte Schichtdicke der inversen Gradientenschicht erreicht ist.

Eine weitere vorteilhafte Möglichkeit zur Ausbildung einer inversen Gradientenschicht ergibt sich wenn zusätzlich zu oder statt des erwähnten Kohlenwasserstoffgases noch siliziumhaltige bzw. silizium- und sauerstoff- bzw. stickstoffhaltige Gase, wie beispielsweise Mono- und Disilane, Siloxane, Hexamethyldisiloxan, Hexamethyldisilazan, Dimethyldiethoxysilan, Tetramethysilan etc. eingelassen werden um die Eigenschaften der Schicht, insbesonders deren Härte und Reibkoeffizienten zu beeinflussen. Damit ist es auch möglich ohne zusätzliches Einschalten eines oder mehrerer Sputtertargets eine Gradientenschicht mit beispielsweise zur Oberfläche hin ansteigendem Silizium-, Sauerstoff- und /oder Stickstoffgehalt herzustellen.

Das Aufbringen einer Gleitschicht als **Gradientendeckschicht**, kann entweder direkt auf einer DLC-Schicht oder nach Aufbringen einer metallischen bzw. karbidischen Zwischenschicht erfolgen.

Beispielsweise wird für die Erzeugung der reibmindernden Deckschicht die dazu verwendete mindestens eine Quelle, ähnlich wie bereits oben beschrieben, allerdings nach stärkerem gegebenefalls auf 0% Absenken des Kohlenstoffgehalts des Prozessgases eingeschaltet.

Zur Herstellung der reibmindernden Deckschicht können karbidische oder metallische Targets verwendet werden, wobei die karbidischen Targets den Vorteil bieten einen insgesamt höheren C-Gehalt, bei sehr hoher Belastbarkeit der Seite Schichten zu ermöglichen. Der Gehalt an graphitischem Kohlenstoff wird wiederum durch Einlassen eines C-haltigen Reaktivgases eingestellt, wobei vorteilhafterweise der Gasfluss ab Einschalten der zur Herstellung der MeC/C-Schicht verwendeten Targets, oder mit einer zeitlichen Verzögerung, mittels einer Rampenfunktion erhöht und am Schluss der Beschichtung für eine bestimmte Zeit konstant gehalten wird.

Eine besonders vorteilhafte Ausführung der Schicht ergibt sich, wenn auf der DLC-Schicht zunächst eine dünne (0.01 -0.9 μm) karbidische, wie zum Beispiel WC-Schicht abgeschieden wird. Überraschenderweise hat sich gezeigt, dass gerade karbidische Schichten besonders gut als Haftvermittler auf einer bereits abgelegte DLC-Schicht geeignet sind. Nach aussen hin wird der Schichtaufbau von einer WC/C-Schicht mit einem zunehmenden C-Gehalt und einer Dicke von ca. 0.1-5 μm abgeschlossen. Vorteilhafterweise wird die Schichtdicke der MeC/C-Schicht geringer als die der reinen DLC-Schicht gewählt.

Eine weitere bevorzugte Ausführung eines erfinderischen DLC-Gleitschichtsystems ergibt sich wenn die abschliessende Gleitschicht auf einer Diamantschicht aufgebracht wird, die beispielsweise mittels einer Hochstromniedervoltbogenentladung oder der Hot-Filament-Technik abgeschieden wurde.

## ANLAGE

Weiterhin wird die oben erwähnte Aufgabe durch Bereitstellung einer Vorrichtung zur Durchführung des oben beschriebenen Beschichtungsverfahrens gelöst, wobei die Vorrichtung eine Vakuumkammer mit einem Pumpsystem zur Erzeugung eines Vakuums in der Vakuumkammer, Substrathalterungen zur Aufnahme der zu beschichtenden Substrate, mindestens einer Gasversorgungseinheit zum Zudosieren von Prozessgas, mindestens eine Verdamper-Vorrichtung zur Bereitstellung von Beschichtungsmaterial zum Aufdampfen, eine Lichtbogenerzeugungseinrichtung zum Zünden eines Gleichspannungsniedervoltbogens, eine Vorrichtung zur Erzeugung einer Substratbiasspannun und mindestens eine oder mehrere Magnetfelderzeugungseinrichtungen zur Ausbildung eines magnetischen Fernfelds umfasst.

Vorzugsweise werden die Magnetfelderzeugungseinrichtungen durch mindestens eine Helmholtzspule, vorzugsweise ein Paar von Helmholtzspulen gebildet.
Bei der Verwendung von Helmholtzspulen ist das erzeugbare Magnetfeld bzw. die Magnetflussdichte durch die Stromstärke in den Spulen sowohl örtlich als auch zeitlich steuerbar.

Eine weitere Möglichkeit zur Erzeugung eines longitudinalen Magnetfeldes ergibt sich, wenn zwei Magnetrons an gegenüberliegenden Seiten des Rezipienten angeordnet werden, und diesen zusätzlich zumindest jeweils eine elektromagnetische Spule zugeordnet ist. Die jeweils zugeordnete Spule wird vorteilhafterweise so angebracht, dass sie im wesentlichen den gesamten seitlichen Umfang der Magnetronanordnung begrenzt. Die Polungen der gegenübeliegenden Magnetronmagnetsysteme werden dabei gegengleich ausgerichtet, d.h. dem Nordpol des einen Systems steht ein Südpol des anderen Systems gegenüber und umgekehrt. Gleichzeitig werden die jeweils zugeordneten Spulen so an eine Stromquelle angeschlossen, dass sich die Felder der Magnetspulen entsprechend einer Helmholtzanordnung zu einem geschlossenen Magnetfeld ergänzen und die Polung der Aussenpole der Magnetronmagnetsysteme und der Magnetspulen gleichsinnig ist. Derartige Vorrichtungen lassen sich vorteilhaft sowohl zur Verstärkung des Magnetronplasmas als auch zur Erhöhung der Ionisation während des Plasma-CVD-Prozeses einsetzen.

Weiterhin umfasst die Vorrichtung eine Vorrichtung zur Erzeugung einer Substratbiasspannung, die kontinuierlich oder schrittweise die angelegte Substratbiasspannun verändern kann und entsprechend auch bipolar oder unipolar betreibbar ist. Insbesondere ist die Vorrichtung geeignet, eine im Mittelfrequenzbereich gepulste Substratbiasspannung zu erzeugen.

Die bei der Vorrichtung verwendeten Verdampfvoirichtungen umfassen Sputtertargets, insbesondere Magnetronsputtertargets, Arcquellen, thermische Verdampfer und dergleichen. Vorteilhaft dabei ist, dass die Verdampfervorrichtung von der übrigen Prozesskammer beispielsweise durch schwenkbare Blenden abtrennbar ist.

Die Vorrichtung weist vorteilhafterweise eine Substratheizung in Form einer induktiven Heizung, Strahlungsheizung oder dergleichen auf, um die Substrate in einem Heizschritt vor der Beschichtung reinigen zu können. Bevorzugt wird aber das Zünden eines Plasmas verwendet.

Unter anderem dazu ist in der Vorrichtung eine Niedervoltbogenerzeugungseinrichtung vorgesehen, die eine Ionenquelle mit einem Filament, vorzugsweise einem Refraktärfilament, insbesondere aus Wolfram, Tantal oder dergleichen in einer Ionisatioskammer sowie eine Anode und eine Gleichspannungsversorgung umfasst. Die Ionenquelle ist hierbei mit dem negativen Pol der Gleichspannungsversorung verbunden. Vorzugsweise kann der positive Pol der Gleichsapnnungsversorgung wahlweise mit der Anode oder den Substrathalterungen verbunden sein, so dass ein Niedervoltlichtbogen zwischen Ionenquelle und Anode oder Ionenquelle und Substraten gezündet werden kann. Auch die Ionenquelle ist ähnlich wie die Verdampfer-Vorrichtung von der eigentlichen Prozesskammer abtrennbar, z.B. durch eine Lochblende, z.B. aus Wolfram, Tantal oder einem ähnlichen Refraktärmetall.

Um einen gleichmässigen Beschichtungsprozess für alle Seiten der Substrate zu ermöglichen, ist es weiterhin vorgesehen, dass die Substrathalterungen beweglich sind und sich vorzugsweise um mindestens eine oder mehrere Achsen drehen können.

Durch die vorteilhafte Kombination der mittelfrequenten Substratspannungsversorung und einer Helmholtz-Spulenanordnung, die auch durch seitlich angebrachte, zwei gegenüberliegende Targets umfassende Spulen verwirklicht werden kann, ist es erstmals im industriellen Massstab möglich auch bei tiefen Drücken ein stabiles Mittelfrequenzplasma zur Durchführung eines DLC-Prozesses zu nutzen. Die damit hergestellten Schichten weisen im Gegensatz zu mit anderen Systemen hergestellten DLC-Schichten stark verbesserte Eigenschaften auf.

Mit vorliegender Beschichtungsanlage und dem oben beschriebenen Verfahren lassen sich erstmals dicke reine DLC-Schichten mit ausgezeichneter Haftung herstellen. Zusätzlich kann bei Änderung der Verfahrensparameter auch ein Grossteil der bisher bekannten Plasmaverfahren zur Herstellung von Metallkohlenstoff- oder Mischschichten mit anderen Elementen wie z.B. Silizium oder F und zur Herstellung von Mehrlagenschichten oder von einfachen, bekannten, mittels PVD- und/oder CVD-Verfahren abgeschieden Schichtsystemen durchgeführt werden.

Weiters lassen sich zusätzlich DLC-Gleitschichtsysteme mit einstellbarem Gleit- und Einlaufverhalten abscheiden.

Weitere Vorteile, Kennzeichen und Merkmale von DLC-Gleitschichtsysteme sind in den der Beschreibung angefiigten Merkmalssätzen enthalten.

Weitere Vorteile, Kennzeichen und Merkmale der Erfindung werden anhand der nachfolgenden detaillierten Beschreibung von bevorzugten Ausführungsformen anhand der beigefügten Zeichnungen deutlich. Dabei zeigen die Figuren sämtlich in rein schematischer Weise in

Figur 1      eine erfindungsgemässe Vorrichtung im Querschnitt

Figur 2      die erfindungsgemässe Vorrichtung der Figur 1 in Draufsicht

Figur 3      Einfluss des Spulenstroms auf den Substratstrom

Figur 4      Prozessparameter Gradientenschicht

Figur 5      Prozessparameter DLC-Schicht

Figur 6      REM-Bruchaufnahme einer erfindungsgemässen DLC-Schicht

Figur 7      Prozessparameter Gesamtverlauf

Figur 8      Prozessparameter graphitisierte DLC-Schicht

Figur 9      Prozessparameter inverse Gradientenschicht

Figur 10     Prozessparameter Gradientenschicht

Figur 11     Prozessparameter $H_2$-reiche Schicht

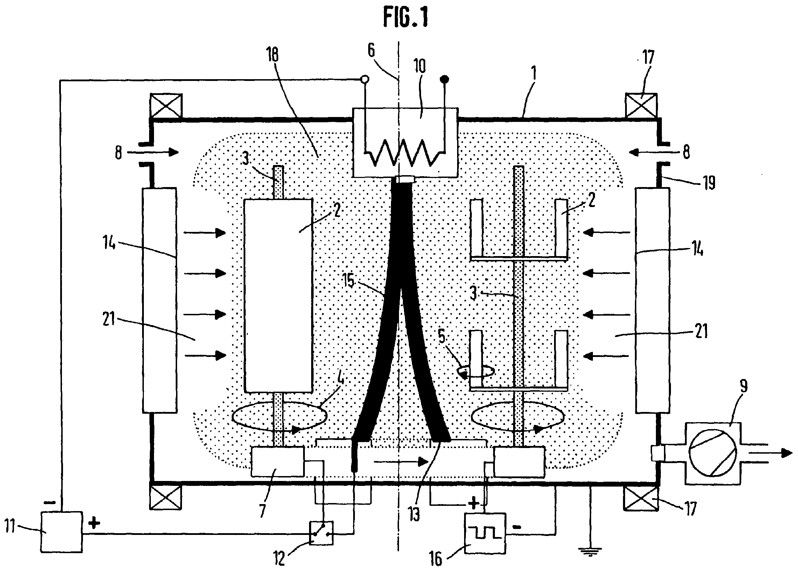

FIG. 1 zeigt einen schematischen Querschnitt durch die Prozesskammer 1 einer erfindungsgemässen Beschichtungsanlage. Die zu beschichtenden Teile 2 sind auf einer bzw. mehreren Halterungsvorrichtungen 3 montiert, die Mittel zur Erzeugung einer zumindest einfachen 4, bei Bedarf auch zweifachen 5 Rotation der Teile umfasst. In einer besonders vorteilhaften Ausführung werden die Halterungsvorrichtungen 3 auf einem zusätzlich um die Anlagenachse 6 drehbaren Karussell 7 positioniert.

Über Gaseinlässe 8 können die unterschiedlichen Prozessgase, insbesondere Ar und Azetylen, in die Prozesskammer mittels geeigneter, hier nicht dargestellten Regelvorrichtungen zugeführt werden.

Ein hochvakuumtauglicher Pumpstand 9 ist an die Kammer angeflanscht.

Eine Ionenquelle 10 ist vorzugsweise im Bereich der Anlagenachse angeordnet, die an den negativen Ausgang einer Gleichspannungsversorgung 11 angeschlossen ist. Der positive Pol der Gleichspannungsversorgung 11 kann je nach Prozessschritt über einen Schalter 12 an das Karussell 7 bzw. an die Halterungsvorrichtung 3 und die damit elektrisch verbundenen Teile 2 (Heizprozess) oder an die Hilfsanode 13 (Aetzprozess, bzw. bei Bedarf auch während der Beschichtungsprozesse) angelegt werden.

An den Wänden der Prozesskammer 1 ist mindestens eine Verdampferquelle 14, bevorzugt ein Magnetron oder ein Lichtbogenverdampfer zum Aufbringen der Haft- und Gradientenschicht vorgesehen. In einer anderen hier nicht dargestellten Ausführungsform der Verdampferquelle 14 kann diese als anodisch geschalteter Tiegel zentral im Boden der Prozesskammer 1 angebracht sein. Dabei wird das Verdampfungsgut zur Herstellung der Uebergangs- oder Gradientenschicht mittels Erhitzen durch den Niedervoltbogen 15 in die Gasphase übergeführt.

Ferner ist eine zusätzliche elektrische Spannungsversorgung 16 vorgesehen, mit deren Hilfe an die Substrate eine periodisch veränderliche Mittelfrequenzspannung im Bereich zwischen 1-10.000, bevorzugt zwischen 20 und 250 kHz angelegt werden kann.

Die elektromagnetischen Spulen 17 zur Erzeugung eines longitudinalen, den Plasmaraum durchdringenden Magnetfelds sind an gegenüberliegenden Begrenzungswänden der Prozesskammer 1 angeordnet und werden durch mindestens eine, vorzugsweise zwei getrennte, hier nicht näher dargestellte DC-Spannungsquellen gleichsinnig gespeist.

Alle Beschichtungsversuche wurden auf einer ähnlich FIG. 1 ausgeführten Prozesskammer folgender Abmessungen durchgeführt:

Kammerhöhe 920 mm, Durchmesser 846 mm, Volumen 560 l.

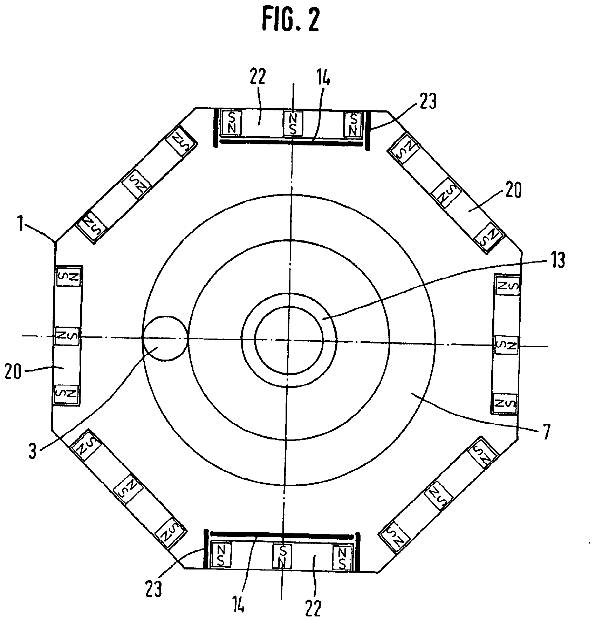

Als zusätzliche Massnahmen zur Verstärkung bzw. gleichmässigeren Ausformung des Magnetfelds und damit des MF-Plasmas 18 können an den Seitenwänden 19 der Plasmakammer 1 Magnetsysteme 20 zur Ausbildung mehrerer magnetischer Nahfelder 21 angebracht werden. Dabei werden vorteilhafterweise gegebenenfalls unter Einbeziehung des mindestens einen Magnetronmagnesystems 22, wie beispielsweise in FIG. 2 dargestellt, abwechselnd Magnetsysteme mit NSN bzw. SNS Polung angeordnet und damit ein magnetischer tunnelförmiger, schleifenförmiger Einschluss des Plasmas in der Prozesskammer bewirkt.

Bevorzugterweise werden die Magnetsysteme 20 für die Nahfelderzeugung als Magnetronmagnetsysteme ausgebildet.

Die einzelnen Systeme der Beschichtungsanlage werden vorteilhafterweise durch eine Prozesssteuerung miteinander in Beziehung gesetzt. Damit ist es möglich, neben den Grundfunktionen einer Vakummbeschichtungsanlage (Pumpstandsteuerung, Sicherheitsregelkreise, etc.), die verschiedenen plasmaerzeugenden Systeme wie Magnetrons mit der hier nicht näher beschriebenen Magnetronversorgung, Ionisationskammer 1 und Hilfsanode 13 bzw. Karussell 7 und Gleichspannungsversorgung 11, sowie Karussell 7 und Mittelfrequenzgenerator 16, sowie die entsprechende Einstellung der Gasflüsse, sowie die Steuerung der gegebenenfalls unterschiedlichen Spulenströme in flexibler Weise aneinander anzupassen und für unterschiedliche Prozesse zu optimieren.

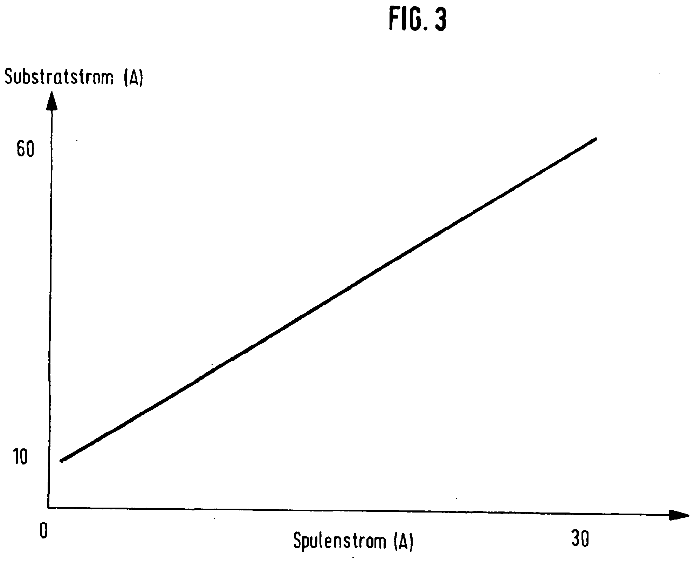

Figur 3 zeigt den Zusammenhang zwischen Substratstrom und Spulenstrom bei Verwendung von Helmholtzspulen zum Aufbau eines Magnetfeldes. Es zeigt sich, dass der Substratstrom, und damit die Plasmaintensität direkt proportional zum Spulenstrom und damit zum Magnetfeldaufbau sind. Dies zeigt deutlich die positive Wirkung eines überlagerten Magnetfeldes.

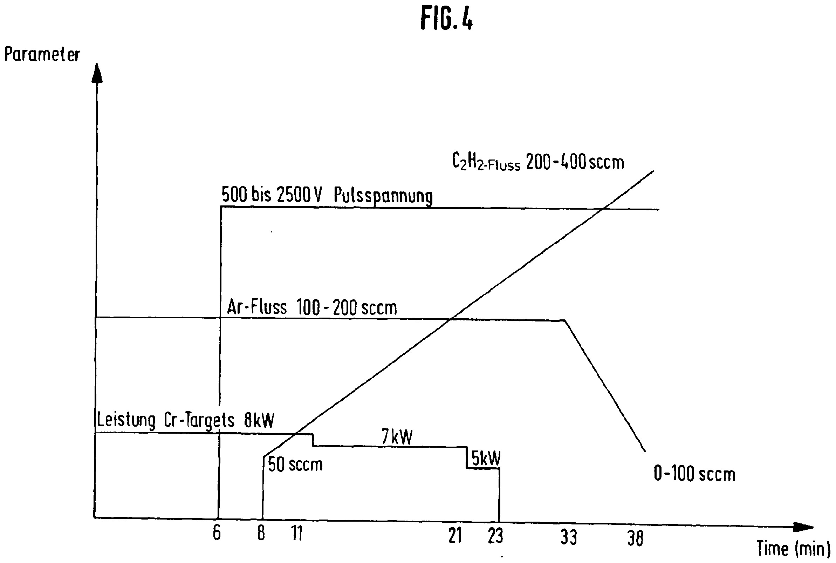

In Figur 4 wird beispielhaft der Verlauf einzelner Parameter während des Aufbringens einer Gradientenschicht dargestellt: Bei sonst gegenüber der Haftschicht gleich bleibenden Parametern wird der Substratbias von Gleichstrom auf Mittelfrequenz mit einer bevorzugten Amplitudenspannung zwischen 500 und 2500 V und einer Frequenz zwischen 20 und 250 kHz, umgeschaltet. Nach ca. 2 Minuten wird eine Acetylenrampe bei 50 sccm gestartet und über ca. 30 Minuten auf 350 sccm gefahren. Ca. 5 Minuten nach Einschalten des Mittelfrequenzgenerators wird die Leistung der verwendeten Cr-Targets auf 7 kW, nach weiteren 10 Minuten auf 5 kW zurückgenommen, und dort noch 2 Minuten konstant gehalten. Anschliessend werden Blenden vor die Targets gefahren und diese abgeschaltet, womit die Abscheidung der im wesentlichen aus Kohlenstoff-, in geringen Mengen Wasserstoff und noch geringeren Mengen Argonatomen aufgebauten "reinen" DLC-Schicht beginnt.

Dazu kann im einfachsten Fall der Prozess mit ausgeschalteten Bedampfungsquellen, im übrigen aber gleichen Parametern wie bei der vorhergehenden Gradientenschicht zu Ende geführt werden. Als vorteilhaft hat es sich jedoch erwiesen, im Laufe der Abscheidung der reinen DLC-Schicht entweder den Kohenwasserstoffanteil im Gasfluss zu erhöhen, den Edelgasanteil abzusenken oder besonders bevorzugt beide Massnahmen gemeinsam durchzuführen. Auch hier kommt wieder einer, wie oben beschriebenen Ausbildung eines longitudinalen Magnetfeldes eine besondere Bedeutung zur Erhaltung eines stabilen Plasmas zu.

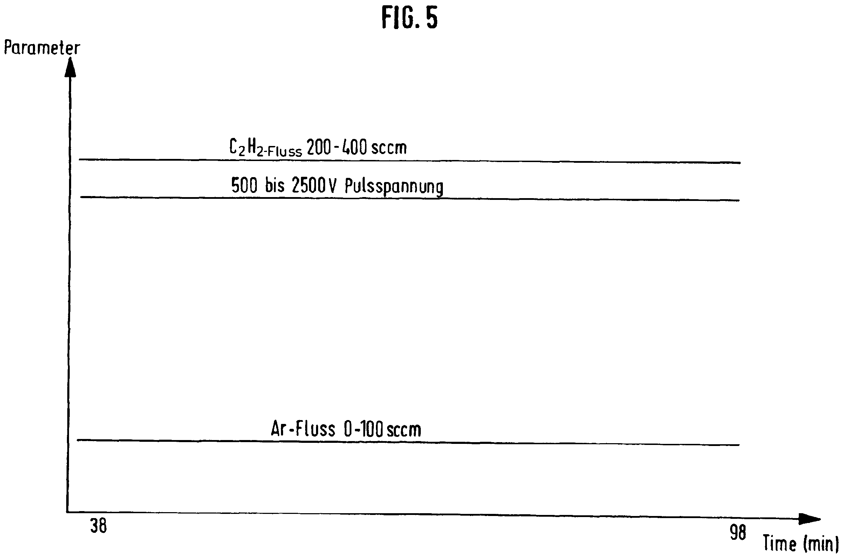

In den Figuren 4 und 5 wird beispielhaft der Verlauf einzelner Parameter während des Aufbringens der reinen DLC-Schicht dargestellt: Nach Abschalten der verwendeten Cr-Targets wird bei gleichbleibend eingestellter Mittelfrequenzversorgung und gleichbleibendem Argonfluss die während der Gradientenschicht begonnene Acetylenrampe ca. 10 Minuten gleichförmig bis zu einem Fluss zwischen ca. 200 - 400 sccm gesteigert. Anschliessend wird der Argonfluss über einen Zeitraum von 5 Minuten kontinuierlich auf einen Fluss zwischen ca. 0 - 100 sccm zurückgenommen. Die nächsten 55 Minuten wird der Prozess bei gleichbleibenden Einstellungen zu Ende gefahren.

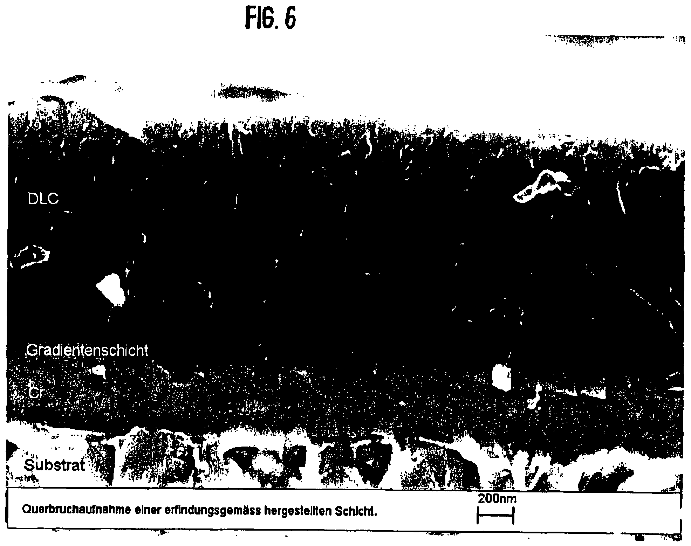

Figur 6 zeigt eine rasterelektronenmikroskopische Aufnahme einer Bruchfläche eines erfindungsgemässen DLC-Schichtsystems. Deutlich ist zu erkennen, dass im Bereich der Deckschicht aus diamantähnlichem Kohlenstoff eine feinkörnige Struktur vorliegt, so dass die DLC-Schicht einen polykristallinen Charakter aufweist.

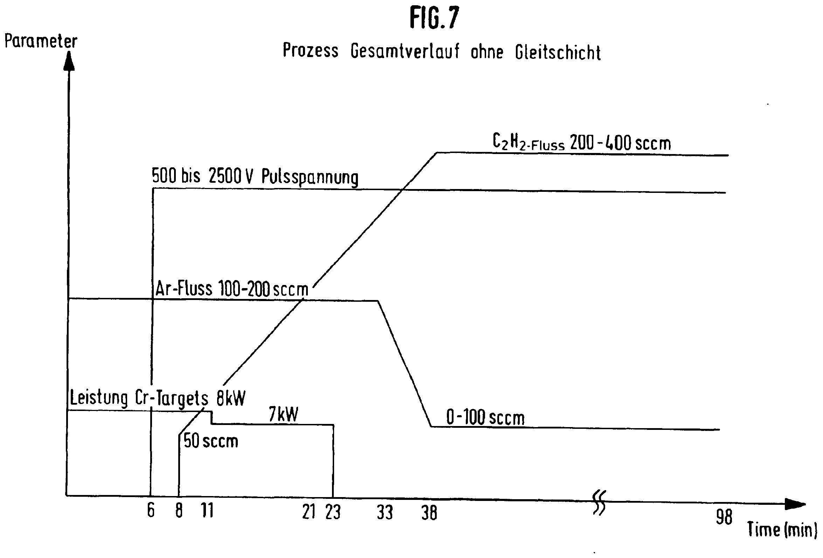

Figur 7 zeigt beispielhaft den Gesamtverlauf einzelner Prozessparameter während des Aufbringens eines erfinderischen DLC-Schichtsystems.

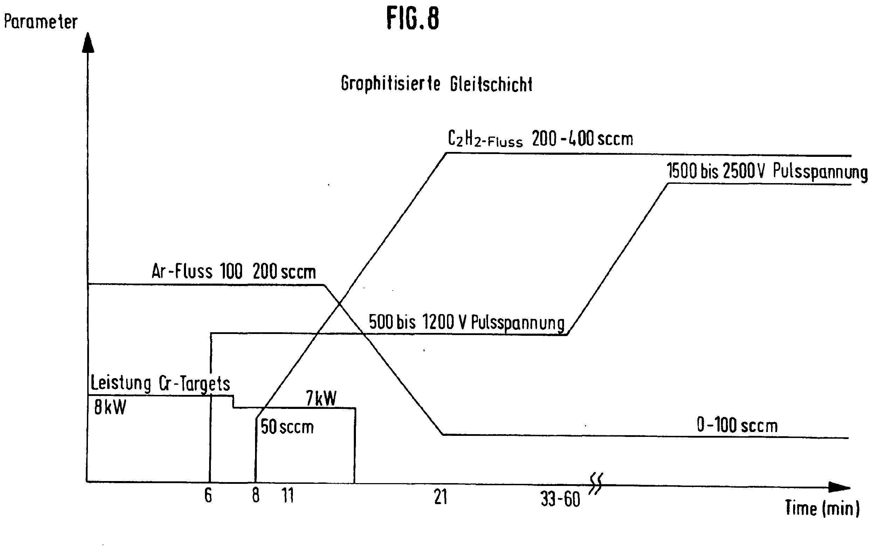

Figur 8 zeigt beispielhaft den Gesamtverlauf einzelner Prozessparameter während des Aufbringens eines erfinderischen DLC-Gleitschichtsystems mit graphitisierter Gleitschicht. Dazu wird nach Aufbringen der DLC-Schicht, je nach gewünschter Schichtdicke beispielsweise nach 33 bis 60 Minuten Beschichtungsdauer, bei sonst gleichbleibenden Prozessparametern, der gepulste Substratbias mittels einer Spannungsrampe auf einen Wert zwischen 1500 und 2500 V eingestellt und anschliessend unter konstanten Bedingungen eine Einlaufschicht abgeschieden.

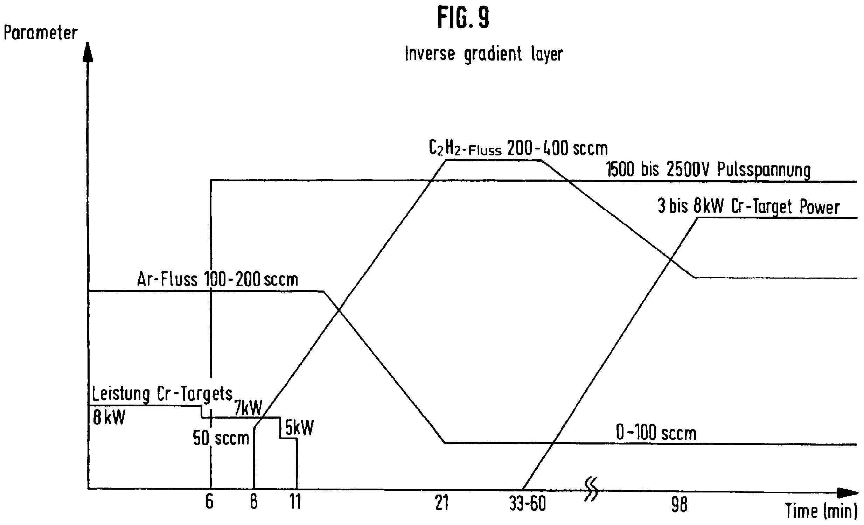

Figur 9 zeigt beispielhaft den Gesamtverlauf einzelner Prozessparameter während des Aufbringens eines erfinderischen DLC-Gleitschichtsystems mit einer inversen Gradientenschicht. Dazu wird nach Aufbringen der DLC-Schicht, je nach gewünschter Schichtdicke beispielsweise nach 33 bis 60 Minuten Beschichtungsdauer, die Leistung das mindestens einen Targets hinter geschlossenen Blenden 10 Minuten, mit 5 kW, hinter den Blenden freigesputtert, anschliessend die Blenden geöffnet und innerhalb von ca. 20 Minuten auf 7 kW hochgefahren. Gleichzeitig wird die Acetylenrampe beispielsweise bei 350 sccm gestartet und über ca. 30 Minuten auf 50 sccm gefahren. Anschliessend wird der Prozess noch bevorzugt unter Konstanthaltung der Einstellungen zu Ende geführt, bis eine gewünschte Schichtdicke der Einlaufschicht erreicht ist.

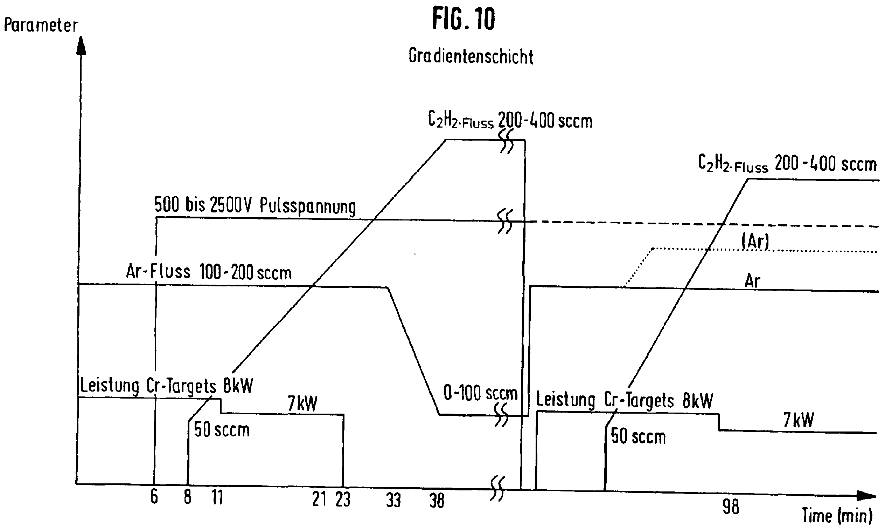

Figur 10 zeigt beispielhaft den Verlauf einzelner Prozessparameter während des Aufbringens einer Gradientenschicht als Gleitschicht. Diese kann ähnlich wie die Übergangsschicht, allerdings auch ohne metallische Haftschicht, ausgeführt werden. Vorteilhafterweise wird auch hier eine Einlaufschicht mit konstanten Parametern als Schichtabschluss vorgesehen.

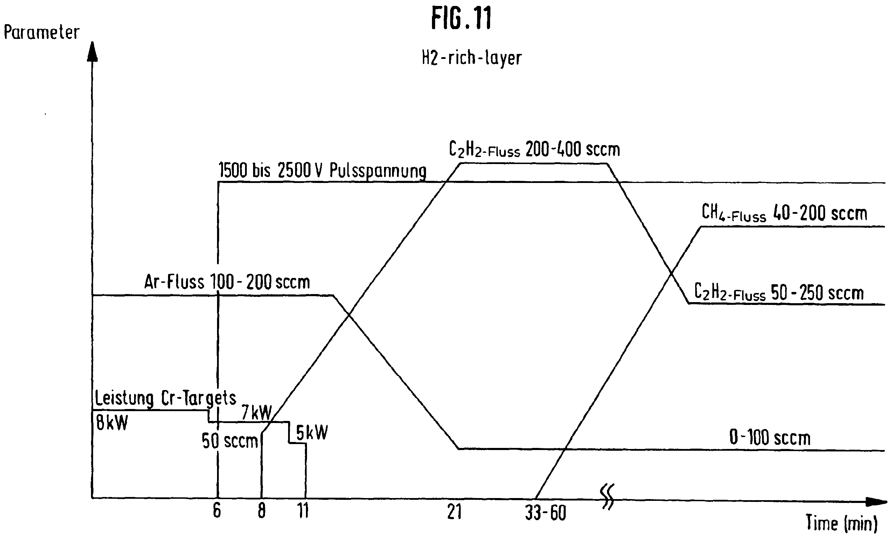

Figur 11 zeigt beispielhaft den Gesamtverlauf einzelner Prozessparameter während des Aufbringens eines erfinderischen DLC-Gleitschichtsystems mit einer $H_2$-reichen Gleitschicht. Dazu wird nach Aufbringen der DLC-Schicht, eine Methanrampe gestartet und beispielsweise über ca. 30 Minuten von 0 auf 100 sccm gefahren. Gleichzeitig wird eine Acetylenrampe beispielsweise bei 350 sccm gestartet und über ca. 30 Minuten auf 120 sccm heruntergefahren. Die Einlaufschicht wird als Schichtabschluss mit konstanten Parametern gefahren.

**Ausführung der Erfindung im Beispiel**

**Prozessbeispiele 1**

**Heizprozess**

Die Prozesskammer wird bis auf einen Druck von etwa 10-5 mbar abgepumpt und die Prozessfolge gestartet. Als erster Teil des Prozesses wird ein Heizprozess durchgeführt, um die zu beschichtenden Substrate auf eine höhere Temperatur zu bringen und von flüchtigen Substanzen an der Oberfläche zu befreien. Bei diesem Prozess wird ein Ar-WasserstoffPlasma mittels des Niedervoltbogens zwischen der Ionisationskammer und einer Hilfsanode gezündet. Die folgende Tabelle 1 zeigt die Prozessparameter des Heizprozesse:

| | |
|---|---|
| Ar-Fluss | 75 sccm |
| Substrat-Bias Spannung [V] | 0 |
| Strom des Niedervoltbogens | 100 A |
| Wasserstoff-Fluss | 170 sccm |
| Strom obere Spule | Schwellend zwischen 20 und 10 A |
| Strom untere Spule | Gegengleich schwellend zwischen 20 und 5 A |
| Periodendauer zwischen max. und min. Spulenstrom | 1.5 min |
| Heizzeit | 20 min |

Die fielmholtzspulen werden zur Aktivierung des Plasmas eingesetzt und werden zyklisch angesteuert. Der Strom der oberen Spule wird dabei mit einer Periodendauer von 1.5 min zwischen 20 und 10 A variiert, der Strom der unteren Spule wechselt im selben Takt gegengleich zwischen 5 und 20 A.

Dabei erwärmen sich die Substrate und die störenden an der Oberflächen anhaftenden flüchtigen Substanzen werden in die Gasatomsphäre getrieben, wo sie von den Vakuumpumpen abgesaugt werden.

**Aetzprozess**

Wenn eine gleichmässige Temperatur erreicht ist, wird ein Aetzprozess gestartet, indem die Ionen aus dem Niedervoltbogen mittels einer negativen Biasspannung von 150V auf die Substrate gezogen werden. Die Ausrichtung des Niedervoltbogens und Intensität des Plasmas werden dabei von dem in horizontaler Ausrichtung angebrachten Helmholtzspulenpaar unterstützt. Folgende Tabelle zeigt die Parameter des Aetzprozesses.

| | |
|---|---|
| Ar-Fluss | 75 sccm |
| Substratspannung | -150 V |

(fortgesetzt)

| Niedervolt-Bogenstrom | 150 A |
|---|---|

**Cr-Haftschicht**

Mit der Aufbringung der Cr-Haftschicht wird begonnen, indem die Cr-MagnetronSputtertargets aktiviert werden. Der Ar-Gasfluss wird auf 115 sccm eingestellt. Die Cr-Sputter-Targets werden mit einer Leistung von 8 kW angesteuert und die Substrate werden nun für eine Zeit von 6 min an den Targets vorbei rotiert. Der sich einstellende Druckbereich liegt dann zwischen 10-3 mbar und 10-4 mbar. Der Sputterprozess wird durch die Zuschaltung des Niedervoltbogens und das Anlegen einer negativen DC-Biasspannung von 75 V am Substrat unterstützt.

Nach der Hälfte der Cr-Sputterzeit wird der Niedervoltbogen abgeschaltet und die Abscheidung wird für den Rest der Cr-Sputterzeit nur mit Hilfe des vor den Cr-Targets aktiven Plasmas getätigt.

**Gradientenschicht**

Nach Ablauf dieser Zeit wird durch Einschalten eines Sinusgenerators ein Plasma gezündet. Acetylengas mit einem Anfangsdruck von 50 sccm eingelassen und der Fluss jede Minute um 10 sccm erhöht. Der Sinus-Plasmagenerator wird dabei bei einer Frequenz von 40 kHz auf eine Amplitudenspannun von 2400 V eingestellt. Der Generator zündet zwischen den Substrathalterungen und der Gehäusewand eine Plasmaentladung. Die am Rezipienten angebrachten Helmholtzspulen sind dabei beide mit einem konstanten Stromdurchfluss von 3 A in der unteren Spule und 10 A in der oberen Spule aktiviert. Bei einem Acetylenfluss von 230 sccm werden die Cr-Targets deaktiviert.

**DLC-Beschichtung**

Wenn der Fluss des Acetylens den Wert von 350 sccm erreicht hat, wird der Ar Fluss auf einen Wert von 50 sccm reduziert.

Die Tabelle zeigt die Parameter des Beispieles im Überblick:

| Fluss Argon | 50 sccm |
|---|---|
| Fluss Acetylen | 350 sccm |
| Anregungsstrom obere Spule | 10 A |
| Anregungsstrom untere Spule | 3 A |
| Spannungsamplitude | 2400 V |
| Anregungsfrequenz f | 40 kHz |

Bei diesen Verhältnissen ist eine hohe Abscheiderate gewährleistet und die Ionisierung des Plasmas wird mit Hilfe des Ar-Gases aufrechterhalten. Die Abscheiderate die sich nun im Beschichtungsprozess einstellt, wird sich im Bereich zwischen 0.5 und 4 $\mu$m/h belaufen, was auch von der zu beschichtenden Fläche in der Prozesskammer abhängt.

Nach Ablauf der Beschichtungszeit wird der Sinus-Generator und der Gasfluss abgestellt, und die Substrate der Prozesskammer entnommen.

Die Eigenschaften der entstehenden Schicht sind der folgenden Tabelle zu entnehmen

| Eigenschaften Beispiel 1 | |
|---|---|
| Mikrohärte | ca. 2200 HK |
| Abscheiderate | 1-2$\mu$m/h |
| Haftung | HF1 |
| Widerstand | <10 k$\Omega$; |
| Wasserstoffgehalt | 12% |
| Reibkoeffizient | 0.2 |

(fortgesetzt)

| Eigenschaften Beispiel 1 | |
|---|---|
| Innere Spannung | ca. 2 GPa |
| Bruchverhalten | Nicht glasig |

**Prozessbeispiel 2**

Prozessbeispiel 2 sieht eine Durchführung ähnlich Beispiel 1 vor. Im Unterschied zu Beispiel 1 wird das Plasma von einem Pulsgenerator erzeugt. Die Anregungsfrequenz liegt bei 50 kHz mit einer Amplituden-Spannung von 700V.
Die Tabelle zeigt die Parameter des 2. Beispiels.

| Fluss Argon | 50 sccm |
|---|---|
| Fluss Acetylen | 350 sccm |
| Anregungsstrom obere Spule | 10 A |
| Anregungsstrom untere Spule | 3 A |
| Spannungsamplitude | 700 V |
| Anregungsfrequenz f | 40 kHz |

Die erzeugte Beschichtung weist eine Härte von 25 GPa, eine Haftfestigkeit von HF1 auf und ergibt einen Reibbeiwert von 0.2.

| Eigenschaften Beispiel 2 | |
|---|---|
| HK | ca. 2400 |
| Abscheiderate | ca. 1.5$\mu$m/h |
| Haftung | HF1 |
| Widerstand | > 500 k$\Omega$ |
| Wasserstoffgehalt | 13% |
| Reibkoeffizient | 0.2 |
| Innere Spannung | Ca. 3 GPa |

**Prozessbeispiel 3**

Prozessbeispiel 3 sieht eine Durchführung ähnlich Beispiel 1 vor. Im Unterschied zu Beispiel 1 wird das Plasma von einer uni-polaren Pulsspannung angeregt, die Parameter des Versuchs zeigt folgende Tabelle.

| Fluss Argon | 50 sccm |
|---|---|
| Fluss Acetylen | 350 sccm |
| Anregungsstrom obere Spule | 10 A |
| Anregungsstrom untere Spule | 3 A |
| Spannungsamplitude | 1150 V |
| Anregungsfrequenz f | 30 kHz |

Die erzeugte Beschichtung weist die in der folgenden Tabelle beschriebene Eigenschaften auf.

| Eigenschaften Beispiel 3 | |
|---|---|
| Mikrohärte | > 2500 HK |
| Abscheiderate | ca. 1.8 $\mu$m/h |
| Haftung | HF1 |
| Widerstand | > 1 k$\Omega$ |
| Wasserstoffgehalt | 12-16% |
| Reibkoeffizient | 0.2 |
| Innere Spannung | ca. 2 GPa |

**Prozessbeispiel 4**

In Vergleich zu Prozessbeispiel 1 wurde im Beispiel 4 ein Prozess ohne Unterstützung durch ein longitudinales Magnetfeld durchgeführt. Der die beiden Spulen durchfliessende Strom wurde auf einen Wert von 0 A reduziert. Die Tabelle zeigt die Prozessparameter.

| Fluss Argon | 50 sccm |
|---|---|
| Fluss Acetylen | 350 sccm |
| Anregungsstrom obere Spule | 0 A |
| Anregungsstrom untere Spule | 0 A |
| Spannungsamplitude | 2400 V |
| Anregungsfrequenz f | 40 kHz |

Es stellt sich ein Plasma ein, das gegenüber Beispiel 1 erst bei höheren Drücken als bei Beispiel 1 stabil ist, inhomogen über die Prozesskammer verteilt ist und von geometrischen Effekten sehr stark beeinflusst ist. Deshalb kommt es zu einer in der Prozesskammer inhomogenen und wegen der bei dem eingestellten Prozessdruck gegenüber Beispiel 1 geringeren Abscheiderate. Bei den angestrebten Prozessdrücken war eine Plasmabildung ohne den Einsatz einer zweiten Plasmaquelle wie z.B. einem Target oder dem Zuschalten des Filamentes nicht möglich. Erst durch den Einsatz der Helmholtzspulen konnte das Plasma in der Prozesskammer stabilisiert werden und eine homogene Abscheidung über die Höhe der Prozesskammer erreicht werden. Ohne den Einsatz der Spulen zündete ein Plasma im Bereich der Ionisationskammer, wo lokal hohe Temperaturen erzeugt werden und Zerstörung befürchtet werden muss.

| Eigenschaften Beispiel 4 | |
|---|---|
| HK | Inhomogen 1200 - 2500 |
| Abscheiderate | Inhomogen |
| Haltung | Nicht bestimmbar |
| Widerstand | Inhomogen |

**Gleitschichtsysteme**

Im Folgenden wurden auf die wie oben beschriebene DLC-Schichten unterschiedliche Gleitschichten aufgebracht, um ein erfindungsgemässes Schichtsystem herzustellen. Dabei ist darauf zu achten, dass der alle Plasmavorbehandlungen und Beschichtungsschritte enthaltende Prozess durchgehend ohne Unterbrechung des Vakuums gefahren wird, um eine optimale Schichthaftung zu erreichen.

**Tabelle 5** zeigt verschiedene Prozessbeispiele mit einer jeweils graphitisierten Gleitschicht:

| Prozessbeispiel | 5 | 6 | 7 |
|---|---|---|---|
| DLC-Schichtsystem Beispiel | wie 1 aber Spannungsampl. 1000V | 2 | 3 |

(fortgesetzt)

| Prozessbeispiel | 5 | 6 | 7 |
|---|---|---|---|
| Fluss Argon | 50 sccm | 50 sccm | 50 sccm |
| Fluss Acetylen | 350 sccm | 350 sccm | 350 sccm |
| Anregungsstrom obere Spule | 10 A | 10 A | 10 A |
| Anregungsstrom untere Spule | 3 A | 3 A | 3 A |
| Substrat-Spannungsamplitude | 2400 V | 2400 V | 2400 V |
| Rampe Spannung | 15 min | 25 min | 15 min |
| Anregungsfrequenz f | 40 kHz | 40 kHz | 30 kHz |
| Anregungstyp | AC-Sinus | bipolarer Puls | unipolarer Puls |

**Tabelle 6** zeigt verschiedene Möglichkeiten zur Ausbildung einer Gleitschichten wie z.B. eine abschliessenden Gradientenschicht (Nr.8), einer inversen Gradientenschicht (Nr.9), bzw. einer wasserstoffreichen C-Schicht (Nr. 10):

| Prozessbeispiel | 8* | 9 | 10 |
|---|---|---|---|
| DLC-Schicht Nr. | 3 | 2 | 2 |
| Fluss Argon 1 | 30 sccm | 50 sccm | 50 sccm |
| Fluss Argon 2 | 30 (100) sccm | - | - |
| Rampe Argon | 0 (10) min | - | - |
| Fluss Acetylen 1 | 0 sccm | 350 sccm | 350 sccm |
| Fluss Acetylen 2 | 250 sccm | 180 sccm | 150 sccm |
| Rampe Acetylen | 15 min | 20 min | 20 min |
| Fluss Methan 1 | - | - | 0 sccm |
| Fluss Methan 2 | - | - | 150 sccm |
| Rampe Methan | - | - | 20 min |
| Leistung Cr-Target 1 | 8 kW | 7 kW | - |
| Leistung Cr-Target 2 | 7 kW | - | - |
| Rampe Cr-Target | 20 min | 30 min | - |
| Anregungsstrom obere Spule | 10 A | 10 A | 10 A |
| Anregungsstrom untere Spule | 3 A | 3 A | 3 A |
| Substrat-Spannungsamplitude | 2400 V | 700 V | 1150 V |
| Anregungsfrequenz f | 40 kHz | 40 kHz | 30 kHz |
| Anregungstyp | AC-Sinus | bipolarer Puls | unipolarer Puls |

\* Die Acetylenrampe kann hierbei auch mit einer zeilichen Verzögerung von 5-10 min nach Einschalten der Cr-Targets gestartet werden. Ein solches Vorgehen ist besonders vorteilhaft, wenn DLC- und Gleitschicht in unterschiedlichen Prozesskammern oder Beschichtungsanlagen aufgebracht werden. Dabei kann auch an Stelle des Sinusgenerators eine Gleichspannungsquelle zum Anlegen des Suabstratbias verwendet werden.

Weiters kann der Graphitanteil durch gleichzeitiges oder ebenfalls verzögert eingeschaltetes Co-Sputtem von karbidischen beispielsweise WC- und/oder Graphittargets erhöht werden. Will man die besonders günstigen Gleiteigenschaften von W- bzw. Ta oder Nb / C-Schichten nutzen, ist es vorteilhaft die Cr-Targets nach Ausbildung einer Haft- bzw. Gradientenschicht abzuschalten, bzw. herunterzuregeln und den Prozess nur mit den entsprechenden Metall- bzw. Metallkarbidtargets zu Ende zu fahren.

Die Eigenschaften der entsprechenden DLC-Schichten sind **Tabelle 8** und

| VersuchNr. | 5 | 6 | 7 |
|---|---|---|---|
| Haftung | HF 1 | HF 1 | HF 1 |
| Widerstand | < 100 kΩ | < 100 kΩ | < 100 kΩ |
| Reibkoeffizient | ca. 0.10 | ca. 0.15 | ca. 0.12 |

**Tabelle 9** zu entnehmen:

| VersuchNr. | 8 | 9 | 10 |
|---|---|---|---|
| Haftung | HF 1 | HF 1 | HF 1 |
| Widerstand | < 1 kΩ | < 1 kΩ | < 100 kΩ |
| Wasserstoffgehalt | n.g. | n.g. | > 30 atom% |
| Reibkoeffizient | ca. 0.08 | ca. 0.07 | ca. 0.13 |

**Bezugszeichenliste**

1. Prozesskammer
2. zu beschichtende Teile
3. Halterungsvorrichtung
4. einfache Rotation
5. zweifache Rotation
6. Anlagenachse
7. Karussell
8. Gaseinlass
9. Pumpstand
10. Ionenquelle
11. Gleichspannungsversorgung
12. Schalter
13. Hilfsanode
14. Verdampferquelle
15. Niedervoltbogen
16. Spannungsversorgung
17. elektromagnetische Spule
18. MF-Plasma
19. Seitenwand
20. Magnetsysteme
21. Nahfelder
22. Magnetronmagnetsysteme

**Patentansprüche**

1. Schichtsystem für den Verschleißschutz, Korrosionsschutz und zur Verbesserung der Gleiteigenschaften und dergleichen auf einem Substrat mit einer Haftschicht zur Anordnung auf einem Substrat, einer Übergangsschicht zur Anordnung auf der Haftschicht, und einer DLC-Schicht, **dadurch gekennzeichnet, dass** auf der DLC-Schicht eine Gleitschicht angeordnet ist, deren chemische Zusammensetzung sich von der Zusammensetzung der DLC-Schicht unterscheidet, wobei der Anteil der sp2-Bindungen bzw. das sp2/sp3-Verhältnis in der Gleitschicht grösser ist als in der DLC-Schicht, wobei die DLC-Schicht eine Dicke von 0,5 $\mu$m bis 20 $\mu$m aufweist, wobei die Haftschicht aus den Elementen Cr oder Ti besteht und die Übergangsschicht im wesentlichen Kohlenstoff und mindestens ein Element aus der Gruppe der Elemente, die die Haftschicht bilden, umfasst.

2. Schichtsystem nach Anspruch 1, **dadurch gekennzeichnet, dass** der Wasserstoffgehalt der Gleitschicht gegenüber dem Wasserstoffgehalt der DLC-Schicht erhöht und der Kohlenstoffgehalt erniedrigt ist.

**3.** Schichtsystem nach Anspruch 2, **dadurch gekennzeichnet, dass** die Gleitschicht einen Wasserstoffgehalt von 20 bis 60 Atom%, vorzugsweise 30 bis 50 Atom% umfasst.

**4.** Schichtsystem nach einem der Ansprüche 1 bis 3, **dadurch gekennzeichnet, dass** die Änderung der Bindungsverhältnisse bzw. der Zunahme des Wasserstoffs über die Dicke der Gleitschicht stufenweise oder kontinuierlich erfolgt.

**5.** Schichtsystem nach Anspruch 1, **dadurch gekennzeichnet, dass** der Metallgehalt der Gleitschicht gegenüber dem Metallgehalt der DLC-Schicht erhöht ist.

**6.** Schichtsystem nach Anspruch 5, **dadurch gekennzeichnet, dass** der Metallgehalt über die Gleitschicht stufenweise oder bevorzugt kontinuierlich zunimmt, der Kohlenstoffgehalt jedoch abnimmt.

**7.** Schichtsystem nach Anspruch 4 und 5, **dadurch gekennzeichnet, dass** im Anschluss an die DLC-Schicht zunächst eine Schicht mit hohem Metallgehalt, bevorzugt eine metallische oder karbidische Schicht, und anschliessend eine Schicht mit fallendem Metall-und wachsendem Kohlenstoffgehalt angeordnet ist.

**8.** Schichtsystem nach einem der vorhergehenden Ansprüche, **dadurch gekennzeichnet, dass** im oberflächennahen Bereich der Gleitschicht ein Schichtbereich konstanter chemischer Zusammensetzung angeordnet ist.

**9.** Schichtsystem nach einem der vorhergehenden Ansprüche, **dadurch gekennzeichnet, dass** der Reibbeiwert der Gleitschichtoberfläche kleiner $\mu = 1.5$ bevorzugt kleiner $\mu = 1.0$ und die Haftung des Schichtsystems besser 3 HF, insbesonders besser 2 HF ist.

**10.** Schichtsystem nach einem der vorhergehenden Ansprüche, **dadurch gekennzeichnet, dass** die Übergangsschicht eine Dicke von 5 bis 60%, insbesonders zwischen 10 und 50% der Gesamtschichtdicke aufweist.

**11.** Schichtsysteme nach einem der vorhergehenden Ansprüche, **dadurch gekennzeichnet, dass** die Haftschicht, die Übergangsschicht, die DLC-Schicht und/oder die Gleitschicht zusätzlich Wasserstoff und/oder unvermeidbare Verunreinigungen umfasst, die unvermeidbaren Verunreinigungen Edelgase, insbesondere Argon und Xenon umfassen.

**12.** Schichtsystem nach einem der vorhergehenden Ansprüche, **dadurch gekennzeichnet, dass** die DLC-Schicht eine Dicke von 0.7 $\mu$m bis 10 $\mu$m aufweist.

**13.** Schichtsystem nach einem der vorhergehenden Ansprüche, **dadurch gekennzeichnet, dass** die Gleitschicht eine Dicke von 0,05 $\mu$m bis 10 $\mu$m, vorzugsweise von 0.5 $\mu$m bis 5 $\mu$m aufweist.

**14.** Schichtsystem nach einem der vorhergehenden Ansprüche, **dadurch gekennzeichnet, dass** die DLC-Schicht aus diamantähnlichem Kohlenstoff mit einer feinkörnigen Schichtstruktur besteht.

**15.** Schichtsystem nach einem der vorhergehenden Ansprüchen, **dadurch gekennzeichnet, dass** die Gleitschicht auf einem DLC-Schichtsystem aufgebracht ist.

**16.** Verfahren zur Herstellung eines Schichtsystems, insbesondere nach einem der Ansprüche 1 bis 15, auf einem Substrat, **dadurch gekennzeichnet, dass** das Verfahren folgende Prozesschritte umfasst:

> a) Einbringen des Substrates in eine Vakuumkammer und Abpumpen bis ein Vakuum mit einem Druck von weniger als 10-3 mbar, vorzugsweise 10-5 mbar erreicht ist.
> b) Reinigen der Substratoberfläche
> c) plasmagestütztes Aufdampfen der Haftschicht auf das Substrat
> d) Aufbringen der Übergangsschicht auf die Haftschicht durch gleichzeitiges plasmagestütztes Aufdampfen der Haftschichtkomponenten und Abscheiden von Kohlenstoff aus der Gasphase
> e) Aufbringen der DLC-Schicht auf die Übergangsschicht durch plasmagestütztes Abscheiden von Kohlenstoff aus der Gasphase,
> f) Aufbringen der Gleitschicht auf die DLC-Schicht durch Abscheiden von Kohlenstoff aus der Gasphase,

wobei zumindest während der Verfahrensschritte c), d), e) und f) am Substrat eine Substratbiasspannung angelegt und zumindest während der Verfahrensschritte d) und e) und bevorzugt auch bei f) das Plasma durch ein Magnetfeld stabilisiert wird.

17. Verfahren nach Anspruch 16, **dadurch gekennzeichnet, dass** zumindest während eines der Prozesschritte b) bis f) eine sinus- bzw. anders geformte bipolare oder unipolare Substratbiasspannung am Substrat angelegt wird, die in einem Mittelfrequenzbereich von 1 bis 10.000 kHz, vorzugsweise 20 bis 250 kHz gepulst ist.

18. Verfahren nach einem der Ansprüche 16 und 17, **dadurch gekennzeichnet, dass** zumindest während einem der Prozesschritte b) bis f), vorzugsweise zumindest während der Prozesschritte d) und e) ein longitudinales, die Substrate umfassendes Magnetfeld mit gleichmässigem Feldinienverlauf angelegt wird, wobei das Magnetfeld zeitlich und/oder räumlich kontinuierlich oder schrittweise veränderbar ist.

19. Verfahren nach einem der Ansprüche 16 bis 18 **dadurch gekennzeichnet, dass** die Übergangsschicht und die Gleitschicht durch zeitgleiches Aufdampfen von mindestens einem Element aus der Gruppe, die die Elemente aus der 4., 5. und 6. Nebengruppe und Silizium enthält, und plasmagestütztem Abscheiden von Kohlenstoff aus der Gasphase gebildet wird, wobei als Reaktionsgas ein kohlenstoffhaltiges Gas, vorzugsweise ein Kohlenwasserstoffgas, insbesondere Acetylen verwendet wird.

20. Verfahren nach einem der vorhergehenden Ansprüche, **dadurch gekennzeichnet, dass** zum Abscheiden der Gleitschicht zunächst eine metallhaltige Schicht, vorzugsweise eine metallische oder karbidische Schicht, auf der DLC-Schicht aufgebracht wird und mit zunehmender Dicke der Gleitschicht in Richtung der Oberfläche der Anteil der Kohlenstoffabscheidung schrittweise oder kontinuierlich erhöht wird.

21. Verfahren nach Ansprüchen 16 bis 20, **dadurch gekennzeichnet, dass** mit zunehmender Dicke der Gleitschicht in Richtung der Oberfläche der Anteil der Kohlenstoffabscheidung schrittweise oder kontinuierlich herabgesetzt und der Anteil der Metall- oder der Wasserstoffabscheidung ehöht wird.

22. Verfahren nach einem der Anspruche 16 bis 21, **dadurch gekennzeichnet, dass** die DLC-Schicht durch Plasma-CVD-Abscheidung von Kohlenstoff aus der Gasphase erzeugt wird, wobei als Reaktionsgas ein kohlenstoffhaltiges Gas, vorzugsweise ein Kohlenwasserstoffgas, insbesondere Acetylen verwendet wird.

23. Verfahren nach einem der Ansprüche 16 bis 22, **dadurch gekennzeichnet, dass** die Prozesschritte b) bis f) unter einem Druck von 10-4 mbar bis 10-2 mbar durchgeführt werden.

24. Vorrichtung zur Beschichtung eines oder mehrerer Substrate, insbesondere zur Durchführung des Beschichtungsverfahrens nach einem der Ansprüche 16 bis 23, mit einer Vakuumkammer (1) mit einem Pumpsystem (9) zur Erzeugung eines Vakuums in der Vakuumkammer (1), Substrathalterungen (3) zur Aufnahme der zu beschichtenden Substrate, mindestens einer Gasversorgungseinheit (8) zum Zudosieren von Prozessgas, mindestens einer Verdampfer-Vorrichtung (14) zur Bereitstellung von Beschichtungsmaterial zum Aufdampfen, einer Lichtbogenerzeugungseinrichtung (10, 143) zum Zünden eines Gleichspannungsniedervoltbogens, einer Vorrichtung (16) zur Erzeugung einer Substratbiasspannung und mit mindestens einer oder mehreren Magnetfelderzeugungseinrichtungen (17) zur Ausbildung eines magnetischen Fernfeldes, wobei die Vorrichtung zur Erzeugung einer Substratbiasspannung so gestaltet ist, dass sie Mittel zum kontinuierlichen oder schrittweisen Verändern der Substratbiasspannung bezüglich des Vorzeichens und/oder der Größe der angelegten Substratbiasspannung und mittel zum Betreiben mit einer bipolaren oder unipolaren Frequenz, vorzugsweise in einem Mittelfrequenzbereich, aufweist, wobei die Magnetfelderzeugungseinrichtung zur Ausbildung eines magnetischen Fernfelds zumindest zwei elektromagnetische Spulen umfasst, **dadurch gekennzeichnet, dass** die elektromagnetischen Spulen jeweils eine von zwei gegenüberliegend angeordneten Magnetronvorrichtungen seitlich umschließen, wobei die Polungen der gegenüberliegenden Magnetronmagnetsysteme definiert und so ausgerichtet sind, dass dem Nordpol des einen Systems ein Südpol des anderen Systems gegenüber steht und gleichzeitig die jeweils zugeordneten Spulen so an eine Stromquelle angeschlossen sind, dass sich die Felder der Magnetspulen zu einem geschlossenen Magnetfeld ergänzen und die Polung der Außenpole der Magnetronmagnetsysteme und der Magnetspulen gleichsinnig sind.

**Claims**

1. Layer system for wear protection, corrosion protection and for improving sliding properties and the like on a substrate with an adhesive layer for arrangement on a substrate, a transition layer for arrangement on the adhesive layer and a DLC layer, **characterized in that** a sliding layer is arranged on the DLC layer, the chemical composition of which is different from the composition of the DLC layer, wherein the proportion of sp2 bonds or the sp2/sp3 ratio is greater in the sliding layer than in the DLC layer, wherein the DLC layer has a thickness of 0.5 $\mu$m to 20 $\mu$m, wherein the adhesive layer consists of the elements Cr or Ti and the transition layer substantially comprises carbon and at least one element from the group of elements which form the adhesive layer.

2. Layer system according to claim 1, **characterized in that** the hydrogen content of the sliding layer is increased relative to the hydrogen content of the DLC layer and the carbon content is lowered.

3. Layer system according to claim 2, **characterized in that** the sliding layer comprises a hydrogen content of 20 to 60 atomic %, preferably 30 to 50 atomic %.

4. Layer system according to any one of claims 1 to 3, **characterized in that** the change in bond ratios or the increase in hydrogen takes place gradually or continuously through the thickness of the sliding layer.

5. Layer system according to claim 1, **characterized in that** the metal content of the sliding layer is increased relative to the metal content of the DLC layer.

6. Layer system according to claim 5, **characterized in that** the metal content increases progressively or preferably continuously in the sliding layer, but the carbon content decreases.

7. Layer system according to claims 4 and 5, **characterized in that** first a layer with a high metal content, preferably a metal or carbide layer, is arranged subsequent to the DLC layer, and then a layer with a decreasing metal content and a rising carbon content is arranged.

8. Layer system according to any one of the preceding claims, **characterized in that** a layer zone of constant chemical composition is arranged in the near-surface zone of the sliding layer.

9. Layer system according to any one of the preceding claims, **characterized in that** the coefficient of friction of the sliding layer surface is less than $\mu$ = 1.5, preferably less than $\mu$ = 1.0, and the adhesion of the layer system is at best 3 HF, particularly at best 2 HF.

10. Layer system according to any one of the preceding claims, **characterized in that** the transition layer has a thickness of 5 to 60%, in particular between 10 and 50% of the total layer thickness.

11. Layer system according to any one of the preceding claims, **characterized in that** the adhesive layer, transition layer, DLC layer and/or sliding layer additionally comprise hydrogen and/or unavoidable impurities, which unavoidable impurities comprise noble gases, in particular argon and xenon.

12. Layer system according to any one of the preceding claims, **characterized in that** the DLC layer has a thickness of 0.7 $\mu$m to 10 $\mu$m.

13. Layer system according to any one of the preceding claims, **characterized in that** the sliding layer has a thickness of 0.05 $\mu$m to 10 $\mu$m, preferably 0.5 $\mu$m to 5 $\mu$m.

14. Layer system according to any one of the preceding claims, **characterized in that** the DLC layer consists of diamond-like carbon with a fine-grained layer structure.

15. Layer system according to any one of the preceding claims, **characterized in that** the sliding layer is applied to a DLC layer system.

16. Method for producing a layer system, in particular according to any one of claims 1 to 15, on a substrate, **characterized in that** the method comprises the following method steps:

   a) introduction of the substrate into a vacuum chamber and evacuation by pumping until a vacuum with a pressure of less than 10-3 mbar, preferably 10-5 mbar, is reached;
   b) cleaning the substrate surface;
   c) vapor-phase plasma-activated application of the adhesive layer to the substrate;

d) application of the transition layer to the adhesive layer by simultaneous vapor-phase plasma-activated application of the adhesive layer components and deposition of carbon from the gas phase;
e) application of the DLC layer to the transition layer by plasma-activated deposition of carbon from the gas phase;
f) application of the sliding layer to the DLC layer by deposition of carbon from the gas phase;

wherein a substrate bias voltage is applied to the substrate at least during method steps c), d), e) and f) and the plasma is stabilized by a magnetic field at least during method steps d) and e) and preferably also f).

17. Method according to claim 16, **characterized in that** a bipolar or unipolar substrate bias voltage of sinusoidal or other form is applied to the substrate at least during one of the method steps b) to f), which is pulsed in an average frequency range of 1 to 10,000 kHz, preferably 20 to 250 kHz.

18. Method according to any one of claims 16 and 17, **characterized in that** a longitudinal magnetic field comprising the substrates with a homogeneous field line pattern is applied at least during one of the method steps b) to f), preferably at least during the method steps d) and e), wherein the magnetic field can be varied continuously or stepwise in time and/or space.

19. Method according to any one of claims 16 to 18, **characterized in that** the transition layer and the sliding layer are formed by simultaneous vapor-phase application of at least one element from the group, which contains elements from the 4., 5. and 6. subgroups and silicon, and by plasma-activated deposition of carbon from the gas phase, wherein a carbon-containing gas, preferably a hydrocarbon gas, in particular acetylene, is used as reaction gas.

20. Method according to any one of the preceding claims, **characterized in that** a metal-containing layer, preferably a metal or carbide layer, is first applied to the DLC layer to deposit the sliding layer, and the proportion of the carbon deposit is increased progressively or continuously as the thickness of the sliding layer increases towards the surface.

21. Method according to claims 16 to 20, **characterized in that** the proportion of carbon deposition is reduced progressively or continuously as the thickness of the sliding layer increases towards the surface and the proportion of metal deposition or hydrogen deposition is increased.

22. Method according to any one of claims 16 to 21, **characterized in that** the DLC layer is produced by plasma-activated chemical vapor deposition of carbon from the gas phase, wherein a carbon-containing gas, preferably a hydrocarbon gas, in particular acetylene, is used as the reaction gas.

23. Method according to any one of claims 16 to 22, **characterized in that** method steps b) to f) are carried out at a pressure of 10-4 mbar to 10-2 mbar.

24. Device for coating one or more substrates, in particular for carrying out the coating method according to any one of claims 16 to 23, with a vacuum chamber (1) with a pumping system (9) for generating a vacuum in the vacuum chamber (1), substrate holders (3) for receiving the substrates to be coated, at least one gas supply unit (8) for metering process gas, at least one evaporator device (14) for supplying coating material to be applied in vapor phase, an arc generation system (10, 143) for igniting a low-voltage DC arc, a device (16) for generating a substrate bias voltage, and with at least one or more magnetic field generation systems (17) for realizing a remote magnetic field, wherein the device for generating a substrate bias voltage is configured such that it has means for continuously or gradually changing the substrate bias voltage with regard to the sign and/or magnitude of the applied substrate bias voltage and means for operating with a bipolar or unipolar frequency, preferably in a medium-frequency range, wherein the magnetic field generating system for realizing a remote magnetic field comprises at least two electromagnetic coils, **characterized in that** the electromagnetic coils each laterally enclose one of two oppositely arranged magnetron devices, in which the polarities of the magnetron magnet systems arranged opposite one another are defined and are oriented in such a way that a south pole of one system faces the north pole of the other system, and the respectively associated coils are simultaneously connected to a current source in such a way that the fields of the magnet coils complement one another to form a closed magnetic field, and the polarity of the outer poles of the magnetron magnet systems and the magnet coils is the same.

**Revendications**

1. Système de couches pour la protection contre l'usure, la protection contre la corrosion et pour l'amélioration des propriétés de glissement et similaires sur un substrat avec une couche adhésive destinée à être disposée sur un substrat, une couche de transition destinée à être disposée sur la couche adhésive, et une couche DLC, **caractérisé en ce qu'**est disposée sur la couche DLC une couche de glissement, dont la composition chimique est différente de la composition de la couche DLC, dans lequel la proportion des liaisons sp2 ou le rapport sp2/sp3 est plus grande/grand dans la couche de glissement que dans la couche DLC, dans lequel la couche DLC présente une épaisseur de 0,5 $\mu$m à 20 $\mu$m, dans lequel la couche adhésive est constituée des éléments Cr ou Ti et la couche de transition comprend sensiblement du carbone et au moins un élément issu du groupe des éléments qui forment la couche adhésive.

2. Système de couches selon la revendication 1, **caractérisé en ce que** la teneur en hydrogène de la couche de glissement est augmentée par rapport à la teneur en hydrogène de la couche DLC et la teneur en carbone est abaissée.

3. Système de couches selon la revendication 2, **caractérisé en ce que** la couche de glissement comprend une teneur en hydrogène de 20 à 60 % atomique, de préférence de 30 à 50 % atomique.

4. Système de couches selon l'une quelconque des revendications 1 à 3, **caractérisé en ce que** la modification des rapports de liaison ou de l'augmentation de l'hydrogène sur l'épaisseur de la couche de glissement a lieu progressivement ou en continu.

5. Système de couches selon la revendication 1, **caractérisé en ce que** la teneur en métal de la couche de glissement est augmentée par rapport à la teneur en métal de la couche DLC.

6. Système de couches selon la revendication 5, **caractérisé en ce que** la teneur en métal augmente progressivement ou de manière préférée en continu sur la couche de glissement, la teneur en carbone diminue toutefois.

7. Système de couches selon la revendication 4 et 5, **caractérisé en ce qu'**est disposée dans le prolongement de la couche DLC en premier lieu une couche avec une teneur en métal élevée, de manière préférée une couche métallique ou de carbure, puis une couche avec une teneur en métal en baisse et une teneur en carbone en hausse est disposée.

8. Système de couches selon l'une quelconque des revendications précédentes, **caractérisé en ce qu'**une zone de couches à composition chimique constante est disposée dans la zone proche de la surface de la couche de glissement.

9. Système de couches selon l'une quelconque des revendications précédentes, **caractérisé en ce que** le coefficient de frottement de la surface de couche de glissement est inférieur à $\mu$ = 1,5, de manière préférée inférieur à $\mu$ = 1,0 et l'adhérence du système de couches est au mieux de 3 HF, en particulier au mieux de 2 HF.

10. Système de couches selon l'une quelconque des revendications précédentes, **caractérisé en ce que** la couche de transition présente une épaisseur de 5 à 60 %, en particulier entre 10 et 50 % de l'épaisseur de couche totale.

11. Système de couches selon l'une quelconque des revendications précédentes, **caractérisé en ce que** la couche adhésive, la couche de transition, la couche DLC et/ou la couche de glissement comprennent en supplément de l'hydrogène et/ou des impuretés inévitables, lesquelles impuretés inévitables comprennent des gaz rares, en particulier de l'argon et du xénon.

12. Système de couches selon l'une quelconque des revendications précédentes, **caractérisé en ce que** la couche DLC présente une épaisseur de 0,7 $\mu$m à 10 $\mu$m.

13. Système de couches selon l'une quelconque des revendications précédentes, **caractérisé en ce que** la couche de glissement présente une épaisseur de 0,05 $\mu$m à 10 $\mu$m, de préférence de 0,5 $\mu$m à 5 $\mu$m.

14. Système de couches selon l'une quelconque des revendications précédentes, **caractérisé en ce que** la couche DLC est constituée de carbone similaire au diamant avec une structure de couches à grains fins.

15. Système de couches selon l'une quelconque des revendications précédentes, **caractérisé en ce que** la couche de glissement est appliquée sur un système de couches DLC.

16. Procédé de fabrication d'un système de couches, en particulier selon l'une quelconque des revendications 1 à 15, sur un substrat, **caractérisé en ce que** le procédé comprend des étapes de processus suivantes :

a) l'introduction du substrat dans une chambre sous vide et l'évacuation par pompage jusqu'à ce qu'un vide avec une pression inférieure à 10-3 mbar, de préférence à 10-5 mbar, soit atteint ;

b) le nettoyage de la surface de substrat ;

c) l'application activée au plasma en phase vapeur de la couche adhésive sur le substrat ;

d) l'application de la couche de transition sur la couche adhésive par application activée au plasma en phase vapeur simultanée des composants de couche adhésive et le dépôt de carbone issu de la phase gazeuse ;

e) l'application de la couche DLC sur la couche de transition par dépôt activé au plasma de carbone issu de la phase gazeuse ;

f) l'application de la couche de glissement sur la couche DLC par dépôt de carbone issu de la phase gazeuse ;

dans lequel une tension de polarisation de substrat est appliquée sur le substrat au moins pendant les étapes de procédé c), d), e) et f) et le plasma est stabilisé par un champ magnétique au moins pendant les étapes de procédé d) et e) et de manière préférée également f).

17. Procédé selon la revendication 16, **caractérisé en ce qu'**une tension de polarisation de substrat bipolaire ou unipolaire de forme sinusoïdale ou autre est appliquée sur le substrat au moins pendant une des étapes de processus b) à f), laquelle est pulsée dans une plage de fréquences moyennes de 1 à 10000 kHz, de préférence de 20 à 250 kHz.

18. Procédé selon l'une quelconque des revendications 16 et 17, **caractérisé en ce qu'**un champ magnétique longitudinal comprenant les substrats avec un tracé de ligne de champ homogène est appliqué au moins pendant une des étapes de processus b) à f), de préférence au moins pendant les étapes de processus d) et e), dans lequel le champ magnétique peut être modifié en continu ou progressivement dans le temps et/ou spatialement.

19. Procédé selon l'une quelconque des revendications 16 à 18, **caractérisé en ce que** la couche de transition et la couche de glissement sont formées par application simultanée en phase vapeur d'au moins un élément issu du groupe, qui contient les éléments issus des 4e, 5e et 6e sous-groupes et de silicium, et par dépôt activé au plasma de carbone issu de la phase gazeuse, dans lequel un gaz contenant du carbone, de préférence un gaz hydrocarbure, en particulier de l'acétylène, est utilisé en tant que gaz de réaction.

20. Procédé selon l'une quelconque des revendications précédentes, **caractérisé en ce qu'**une couche contenant du métal, de préférence une couche métallique ou de carbure, est appliquée en premier lieu sur la couche DLC pour déposer la couche de glissement, et la proportion du dépôt de carbone est augmentée progressivement ou en continu au fur et à mesure que l'épaisseur de la couche de glissement augmente en direction de la surface.

21. Procédé selon les revendications 16 à 20, **caractérisé en ce que** la proportion du dépôt de carbone est réduite progressivement ou en continu au fur et à mesure que l'épaisseur de la couche de glissement augmente en direction de la surface et la proportion du dépôt de métal ou du dépôt d'hydrogène est augmentée.

22. Procédé selon l'une quelconque des revendications 16 à 21, **caractérisé en ce que** la couche DLC est produite par dépôt chimique en phase vapeur activé par plasma de carbone issu de la phase gazeuse, dans lequel un gaz contenant du carbone, de préférence un gaz hydrocarbure, en particulier de l'acétylène, est utilisé en tant que gaz de réaction.

23. Procédé selon l'une quelconque des revendications 16 à 22, **caractérisé en ce que** les étapes de processus b) à f) sont mises en œuvre à une pression de 10-4 mbar à 10-2 mbar.

24. Dispositif de revêtement d'un ou de plusieurs substrats, en particulier de mise en œuvre du procédé de revêtement selon l'une quelconque des revendications 16 à 23, avec une chambre sous vide (1) avec un système de pompage (9) destiné à produire un vide dans la chambre sous vide (1), des fixations de substrat (3) destinées à recevoir les substrats à revêtir, au moins une unité d'alimentation en gaz (8) destinée à doser du gaz de processus, au moins un dispositif évaporateur (14) destiné à fournir du matériau de revêtement à appliquer en phase vapeur, un système de production d'arc électrique (10, 143) destiné à allumer un arc basse tension à tension continue, un dispositif (16) destiné à produire une tension de polarisation de substrat, et avec au moins un ou plusieurs systèmes de production de champ magnétique (17) destinés à réaliser un champ magnétique éloigné, dans lequel le dispositif destiné à produire une tension de polarisation de substrat est configuré de telle sorte qu'il présente des moyens destinés à modifier en continu ou progressivement la tension de polarisation de substrat quant au signe et/ou à la grandeur de la tension de polarisation de substrat appliquée et des moyens destinés à fonctionner avec une fréquence bipolaire ou unipolaire, de préférence dans une plage de fréquences moyennes, dans lequel le système de production de champ magnétique destiné à réaliser un champ magnétique éloigné comprend au moins deux bobines électromagnétiques, **caractérisé en ce que** les bobines électromagnétiques renferment latéralement respectivement un de deux dispositifs à magnétron disposés en vis-à-vis, dans lequel les polarités des systèmes magnétiques à magnétron disposés en vis-à-vis sont définies et sont orientées de telle sorte qu'un pôle sud d'un système est en regard du pôle nord de l'autre système et les bobines respectivement associées sont raccordées simultanément à une source de courant de telle sorte que les champs des bobines magnétiques se complètent en un champ magnétique fermé et la polarité des pôles extérieurs des systèmes magnétiques à magnétron et des bobines magnétiques sont de même sens.

FIG.1

# FIG. 2

EP 1 272 683 B2

# FIG. 3

EP 1 272 683 B2

FIG.4

Parameter

C$_2$H$_2$-Fluss 200-400 sccm

500 bis 2500 V  Pulsspannung

Ar-Fluss  100 - 200 sccm

Leistung Cr-Targets 8kW

7 kW

50 sccm

5kW

0-100 sccm

6  8  11          21  23    33    38

Time (min)

EP 1 272 683 B2

## FIG. 5

Parameter

$C_2H_2$-Fluss 200 - 400 sccm

500 bis 2500 V Pulsspannung

Ar-Fluss 0 -100 sccm

38

98  Time (min)

EP 1 272 683 B2

EP 1 272 683 B2

## FIG. 6

DLC

Gradientenschicht

Cr

Substrat

200nm

Querbruchaufnahme einer erfindungsgemäss hergestellten Schicht.

# FIG.7

### Prozess Gesamtverlauf ohne Gleitschicht

Parameter

$C_2H_2$-Fluss 200–400 sccm

500 bis 2500 V Pulsspannung

Ar-Fluss 100–200 sccm

Leistung Cr-Targets 8kW

7kW

50 sccm

0–100 sccm

6  8  11        21 23    33    38                    98  Time (min)

EP 1 272 683 B2

# FIG.8

Grophitisierte Gleitschicht

$C_2H_2$-Fluss 200 – 400 sccm

1500 bis 2500 V Pulsspannung

Ar-Fluss 100  200 sccm

500 bis 1200 V Pulsspannung

Leistung Cr-Targets

8 kW

7 kW

50 sccm

0 – 100 sccm

Parameter

6   8   11                    21           33-60

Time (min)

EP 1 272 683 B2

FIG. 9

Inverse gradient layer

## FIG. 10

### Gradientenschicht

C₂H₂-Fluss 200-400 sccm

$C_2H_2$-Fluss 200-400 sccm

$C_2H_2$-Fluss 200-400 sccm

500 bis 2500V Pulsspannung

(Ar)

Ar-Fluss 100-200 sccm

Ar

Leistung Cr-Targets 8kW

7 kW

50 sccm

0-100 sccm

Leistung Cr-Targets 8kW

7 kW

50 sccm

Parameter

Time (min)

6  8  11        21 23    33  38              98

EP 1 272 683 B2

# FIG.11

H2-rich-layer

Parameter

$C_2H_2$-Fluss 200-400 sccm

1500 bis 2500 V Pulsspannung

$CH_4$-Fluss 40-200 sccm

Ar-Fluss 100-200 sccm

$C_2H_2$-Fluss 50-250 sccm

Leistung Cr-Targets

7kW

8kW

50 sccm

5kW

0-100 sccm

6   8   11                    21        33-60

Time (min)

EP 1 272 683 B2

**EP 1 272 683 B2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 87836 A
- DE 4343354 A1
- US 5078848 A
- EP 651069 A
- EP 600533 A
- EP 885983 A
- EP 856592 A
- US 4728529 A
- DE 19513614 C
- DE 19826259 A
- US 5707748 A
- WO 9955929 A